# EUROPEAN PATENT SPECIFICATION

(11) **EP 0 732 783 B1**
(45) Date of publication and mention of the grant of the patent: **09.01.2002**
(21) Application number: 95113049.1
(22) Date of filing: 18.08.1995
(51) Int. Cl.: H01S 5/10, G02B 5/18

(54) **Semiconductor laser and a method of producing the same**
Halbleiterlaser und Verfahren zu seiner Herstellung
Laser à semi-conducteur et une méthode de fabrication

(30) Priority: 17.03.1995 JP 5925695
(43) Date of publication of application: 18.09.1996
(73) Proprietor: MITSUBISHI DENKI KABUSHIKI KAISHA, Tokyo (JP)
(72) Inventor: Hisa, Yoshihiro, c/o Mitsubishi Denki K.K., Itami-shi, Hyogo 664 (JP)
(74) Representative: Winter, Brandl, Fürniss, Hübner, Röss, Kaiser, Polte Partnerschaft

(56) References cited:
- EP-A- 0 439 236
- EP-A- 0 461 632
- EP-A- 0 533 485
- EP-A- 0 632 298
- FR-A- 2 647 276
- PATENT ABSTRACTS OF JAPAN vol. 017, no. 518 (E-1434), 17 September 1993 & JP-A-05 136521 (FUJITSU LTD), 1 June 1993,
- JOURNAL OF THE ELECTROCHEMICAL SOCIETY, vol. 140, no. 8, August 1993, MANCHESTER, US, pages 2414-2421, XP000403639 T.NISHIDA ET AL.: "Microloading effect in InP wet etching"
- PROCEEDINGS OF THE MATERIALS RESEARCH SOCIETY SYMPOSIUM ON COMPOUND SEMICONDUCTOR EPITAXY, vol. 340, 4 April 1994, PITTSBURGH, US, pages 153-158, XP000574428 P.TIDEMAND-PETERSSON ET AL.: "Application of selective area MOVPE for DFB gratings with modulated coupling coefficient"

## Description

The present invention relates to a semiconductor laser used for optical commutation systems and a method of producing the same.

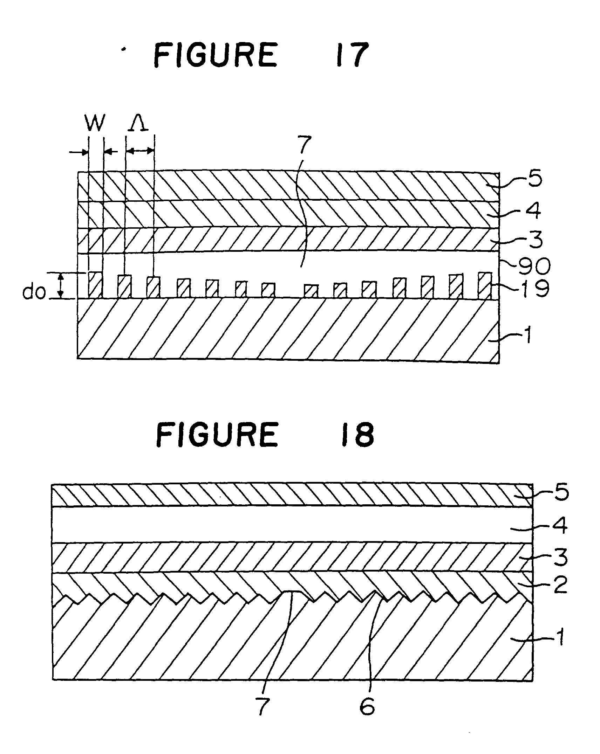

Figure 18 is a cross-sectional view of a waveguide portion in a distributed feed back semiconductor laser widely used for optical communication, which is disclosed, for instance, in Japanese Patent Publication No. JP-A-4111383. Figure 18 shows a cross-sectional surface taken in parallel to the waveguide path of the semiconductor laser wherein a diffraction grating 6, a lower cladding layer 2 composed of a p-InGaAsP, an. active layer 3 composed of InGaAsP, an upper cladding layer 4 of n-InP and a contact layer 5 of n⁺-InGaAsP are successively formed on a p-InP substrate 1. Further, a λ/4 shift portion 7 is formed in the diffraction grating by shifting its phase by λ/4.

When an electric current is passed in the semiconductor laser having the above-mentioned construction, light is generated in the active layer 3 due to recombination of carries. Since the semiconductor laser has such construction that the active layer having a large refractive index and the lower cladding layer 2 are interposed in the direction of lamination between the p-InP substrate 1 having a smaller refractive index and the upper cladding layer 4, the light generated is propagated in the active layer 3, the lower cladding layer 2 and the vicinity thereof in the direction of lamination. The propagated light is reflected at left and right end surfaces, and light components having an agreed phase mutually increase the intensity of light. Further, since the diffraction grating 6 has a distribution feed back structure, light having substantially uniform mode can be obtained. In addition, since the diffraction grating 6 has the λ/4 shift portion 7 formed by shifting its phase by λ/4, there occurs a phase inversion at the λ/4 shift portion 7 during the propagation of light, and the light having a single wavelength is emitted.

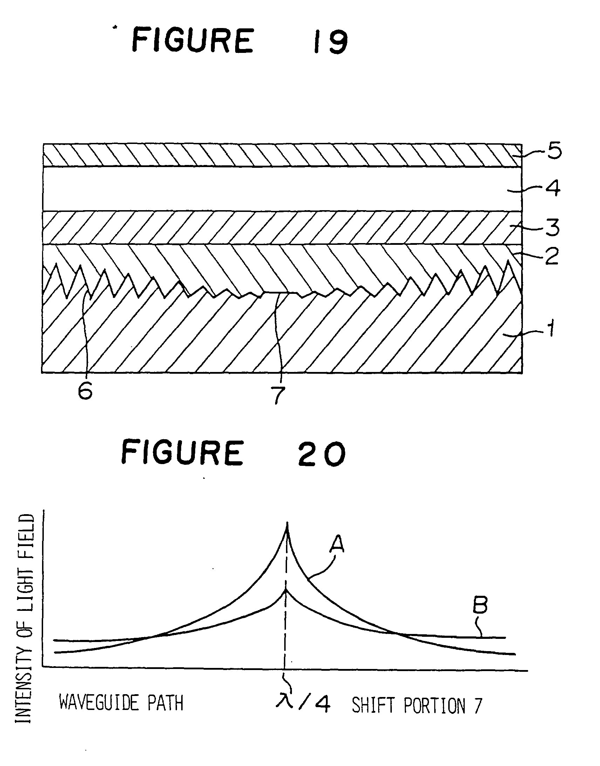

In the convectional semiconductor laser as shown in Figure 18 in which the λ/4 shift portion 7 is formed in the diffraction grating 6, however, the intensity of light field is extremely strong at the λ/4 shift portion 7 as shown by a character A in Figure 20, and there easily occurs a so-called hole burning, whereby the mode of light may become unstable in a high output of light.

In order to suppress the occurrence of the hole burning, there has been used a structure wherein the height of the diffraction grating 6 is gradually decreased in the direction of the λ/4 shift portion 7 to thereby reduce the reflectance of light, as shown in Figure 19. According to this construction, an increase of the light intensity at the λ/4 shift portion 7 can be prevented as shown by a character B in Figure 20.

In order to obtain the structure shown in Figure 19 wherein the height of the diffraction grating 6 is gradually reduced in the direction of the λ/4 shift portion 7, the p-InP substrate 1 is etched so that the quantity of etching is partially or continuously changed whereby the diffraction grating 6 whose pitch is partially or continuously changed is formed.

However, it is very difficult in technique to partially or continuously change an etching quantity for the p-InP substrate 1 so as to form the diffraction grating 6 whose height is partially or continuously changed. Generally, the pitch of the diffraction grating is in a range of about 0.2 µm - about 0.3 µm. However, such structure further makes the formation of the diffraction grating 6 difficult.

Besides the diffraction grating 6 formed in the surface of the p-InP substrate 1 shown in Figure 19, there has been proposed an embedding structure type diffraction grating as shown in Figures 21 and 22 in Japanese Patent Publication No. JP-A-2307287.

Figure 21 shows a semiconductor laser wherein on a p-InP substrate, a buffer layer 8 composed of p-InP, an active layer 3 of InGaAsP which has a smaller energy gap than the buffer layer 8, a barrier layer 9 of n-InP which has a larger energy gap than the active layer 3, an embedded diffraction grating 10 of n-InGaAsP which has a larger energy gap than the active layer 3 but a smaller energy gap than the barrier layer 9, an upper cladding layer 4 of n-InP which has the same composition as the barrier layer 9 and a contact layer 5 of n+-InGaAsP are successively formed wherein the diffraction grating 10 has a constant pitch Λ, a constant width W and a constant height d₀ in which a λ/4 shift portion 7 is formed in the diffraction grating by shifting the phase of grating by λ/4.

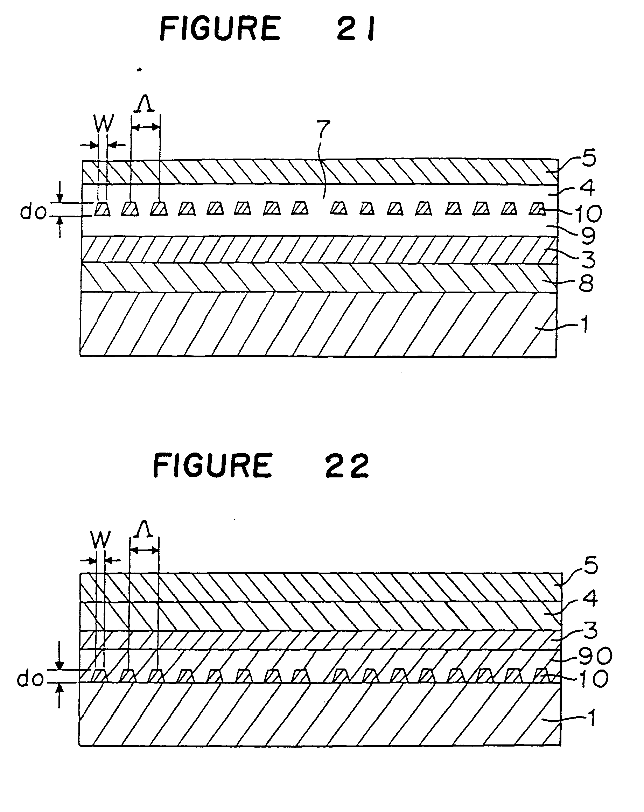

Figure 22 shows a semiconductor laser wherein a p-InP substrate 1, an embedded diffraction grating 10 composed of p-InGaAsP which has a smaller energy gap than the p-InP substrate 1, a barrier layer 90 of p-InP which has the same composition as the p-InP substrate 1, an active layer 3 having a smaller energy gap than the embedded diffraction grating 10, an upper cladding layer 4 of n-InP and a contact layer 5 of n⁺-InGaAsP are successively formed and wherein the embedded diffraction grating 10 has a constant pitch λ, a constant width W and a constant height d₀ and a λ/4 shift portion 7 is formed in the diffraction grating by shifting its phase by λ/4.

FR-A-2647276 discloses a phase shift distributed feedback type semiconductor laser device comprising a semiconductor substrate; an active layer formed above the semiconductor substrate, which has a smaller energy gap than the semiconductor substrate; a barrier layer formed on the active layer, which has a larger energy gap than the active layer; and an embedded diffraction grating which is composed of stripes, each having a width along the resonator direction, a length in the direction perpendicular to the resonator direction, and a height, and which is embedded between the barrier layer and the cladding layer having the same composition as the barrier layer so as to extend with the parallel arrangement at a constant pitch outside the λ/4 phase shift portion and along the resonator direction, wherein the height of the stripes is constant and the width of the stripes is changed along the resonator direction, i.e. the width of the single stripe in the phase shift portion is larger than the width of the other stripes.

It is an object of the present invention to eliminate the above-mentioned problems in the semiconductor lasers having the embedded diffraction grating 10 as shown in Figures 21 and 22, and to provide a semiconductor laser and a method of producing the same wherein a diffraction grating capable of producing a stable mode of light in a high light output range, which was difficult to form by the etching of the p-InP substrate in conventional techniques, can be easily and accurately obtained.

This object is achieved with a semiconductor laser according to claims 1,2,5 and 6, and a method according to claims 11-13, 15, 16, 19 and 20.

In the invention defined in Claim 1, there is provided a semiconductor laser which comprises:
a semiconductor substrate;
an active layer formed above the semiconductor substrate, which has a smaller energy gap than the semiconductor substrate;
a barrier layer formed on the active layer, which has a larger energy gap than the active layer; and
an embedded diffraction grating which comprises a λ/4 phase shift portion substantially in the central portion thereof and which is composed of stripes, each having a width along the direction of the waveguide path, i.e. the resonator direction, a length in the direction perpendicular to the direction of the waveguide path respectively resonator direction, and a height, and which is embedded between the barrier layer and a cladding layer having the same composition as the barrier layer so as to extend with a parallel arrangement at a constant pitch outside the λ/4 phase shift portion along the resonator direction,
wherein the height of the stripes is constant and the width of the stripes is gradually changed along the direction of the waveguide path respectively resonator direction such as to suppress the occurrence of hole burning.

In the invention defined in Claim 2, there is provided a semiconductor laser which comprises:
a semiconductor substrate;
an embedded diffraction grating which comprises a λ/4 phase shift portion substantially in the central portion thereof and which is composed of stripes, each having a width along the direction of the waveguide path, i.e. the resonator direction, a length in the direction perpendicular to the direction of the waveguide path respectively resonator direction, and a height, and which is embedded between the semiconductor substrate and a barrier layer having the same composition as the semiconductor substrate so as to extend with a parallel arrangement at a constant pitch outside the λ/4 phase shift portion and along the resonator direction, wherein the height of the stripes is constant and the width of the stripes is gradually changed along the direction of the waveguide path respectively resonator direction such as to suppress the occurence of hole burning; and
an active layer which is formed on the barrier layer and which is composed of material having a smaller energy gap than the semiconductor substrate.

In the invention defined in Claim 3, there is provided a semiconductor laser according to Claim 1 or 2, wherein said λ/4 shift portion is formed in substantially the central portion of the embedded diffration grating by shifting the phase of the embedded diffraction grating by λ/4 (λ: wavelength of light), and the width of the embedded diffraction grating is gradually reduced in the direction of the λ/4 shift portion.

In the invention defined in Claim 4, there is provided a semiconductor laser according to Claim 1 or 2, wherein said λ/4 shift portion is formed in substantially the central portion of the embedded diffraction grating by shifting the phase of the embedded diffraction grating by λ/4 (λ: wavelength of light), and the width of the embedded diffraction grating is gradually increased in the direction of the λ/4 shift portion.

In the invention defined in Claim 5, there is provided a semiconductor laser which comprises:
a semiconductor substrate;
an active layer formed above the semiconductor substrate, which has a smaller energy gap than the semiconductor substrate;
a barrier layer formed on the active layer, which has a larger energy gap than the active layer; and
an embedded diffraction grating which comprises a λ/4 phase shift portion substantially in the central portion thereof and which is composed of stripes, each having a width along the direction of the waveguide path, i.e. the resonator direction, a length in the direction perpendicular to the direction of the waveguide path respectively resonator direction, and a height, and which is embedded between the barrier layer and a cladding layer having the same composition as the barrier layer so as to extend with a parallel arrangement at a constant pitch outside the λ/4 phase shift portion and along the resonator direction, wherein the width of the stripes is constant and the height of the stripes is changed along the direction of the waveguide path respectively resonator direction such as to suppress the occurence of hole burning.

In the invention defined in Claim 6, there is provided a semiconductor laser which comprises:
a semiconductor substrate;
an embedded diffraction grating which comprises a λ/4 phase shift portion substantially in the central portion thereof and which is composed of stripes, each having a width along the direction of the waveguide path, i.e. the resonator direction, a length in the direction perpendicular to the direction of the waveguide path respectively resonator direction, and a height, and which is embedded between the semiconductor substrate and a barrier layer having the same composition as the semiconductor substrate so as to extend with a parallel arrangement at a constant pitch outside the λ/4 phase shift portion and along the resonator direction, wherein the width of the stripes is constant and the height of the stripes is changed along the direction of the waveguide path respectively resonator direction such as to suppress the occurence of hole burning ; and
an active layer which is formed on the barrier layer and which is composed of material having a smaller energy gap than the semiconductor substrate.

In the invention defined in Claim 7, there is provided a semiconductor laser according to Claim 5 or 6, wherein said λ/4 shift portion is formed in substantially the central portion of the embedded diffraction grating by shifting the phase of the embedded diffraction grating by λ/4 (λ: wavelength of light), and the height of the embedded diffraction grating is gradually reduced in the direction of the λ/4 shift portion.

In the invention defined in Claim 8, there is provided a semiconductor laser according to Claim 5 or 6, wherein said λ/4 shift portion is formed in substantially the central portion of the embedded diffraction grating by shifting the phase of the embedded diffraction grating by λ/4 (λ: wavelength of light), and the height of the embedded diffraction grating is gradually increased in the direction of the λ/4 shift portion.

In the invention defined in Claim 9, there is provided a semiconductor laser according to anyone of Claims 1 to 8, wherein the refractive index of the embedded diffraction grating is different from that of the barrier layer.

In the invention defined in Claim 10, there is provided a semiconductor laser according to anyone of Claims 1 to 8, wherein the energy gap of the embedded diffraction grating is larger than that of the active layer and smaller than that of the barrier layer.

In the invention defined in Claim 11, there is provided a method of producing a semiconductor laser which comprises:
a step of successively forming on a semiconductor substrate an active layer having a smaller energy gap than the semiconductor substrate, a barrier layer having a larger energy gap than the active layer and an diffraction grating layer;
a step of forming a photoresist on the diffraction grating layer;
a step of light-exposing and developing the photoresist to thereby form an etching mask having stripe-like openings which are arranged at a predetermined pitch outside a substantially central λ/4 phase shift portion of the diffraction grating layer and along the direction of the waveguide path, i.e. the resonator direction, wherein the widths of the openings are gradually changed along the direction of the waveguide path respectively resonator direction such as to suppress the occurence of hole burning, and
a step of etching portions of the embedded diffraction grating layer exposed in the openings.

In the invention defined in Claim 12, there is provided a method of producing a semiconductor laser which comprises:
a step of forming an diffraction grating layer on a semiconductor substrate;
a step of forming a photoresist on the diffraction grating layer;
a step of light-exposing and developing the photoresist to thereby form an etching mask having stripe-like openings which are arranged at a predetermined pitch outside a substantially central λ/4 phase shift portion of the diffraction grating layer and along the direction of the waveguide path, i.e. the resonator direction, wherein the widths of the openings are gradually changed along the direction of the waveguide path respectively resonator direction such as to suppress the occurence of hole burning;
a step of etching portions of the diffraction grating layer exposed in the openings;
a step of covering the diffraction grating layer with a barrier layer having the same composition as the semiconductor substrate, and
a step of forming on the barrier layer an active layer having a smaller energy gap than the semiconductor substrate.

In the invention defined in Claim 13, there is provided a method of producing a semiconductor laser, wherein a step of conducting an electron beam exposure of the photoresist is conducted by gradually changing a dose quantity of electron beams along the direction of the waveguide path, i.e. the resonator direction.

In the invention defined in Claim 14, there is provided a method of producing a semiconductor laser according to Claim 11 or 12, wherein light exposure is conducted by superposing a first light exposure using an interference light exposure method for irradiating light having a sinusoidal wave-pattern of light intensity, on a second light exposure for irradiating light having a pattern of light intensity in which the light intensity is gradually changed along the direction of waveguide path, i.e. the resonator direction.

In the invention defined in Claim 15, there is provided a method of producing a semiconductor laser which comprises:
a step of successively forming on a semiconductor substrate an active layer having a smaller energy gap than the semiconductor substrate, a barrier layer having a larger energy gap than the active layer and an diffraction grating layer;
a step of forming a photoresist on the diffraction grating layer;
a step of light-exposing and developing the photoresist to thereby form an etching mask having stripe-like openings which are arranged at a predetermined pitch outside a substantially central λ/4 phase shift portion of the diffraction grating layer and along the direction of the waveguide path, i.e. the resonator direction, wherein the widths of the openings along the resonator direction are constant, and the length of the openings in the direction perpendicular to the resonator direction is gradually changed along the direction of the waveguide path respectively resonator direction such as to suppress the occurence of hole burning, and
a step of etching portions of the diffraction grating layer exposed in the openings.

In the invention defined in Claim 16, there is provided a method of producing a semiconductor laser which comprises:
a step of forming an diffraction grating layer on a semiconductor substrate;
a step of forming a photoresist on the diffraction grating layer;
a step of light-exposing and developing the photoresist to thereby form an etching mask having stripe-like openings which are arranged at a predetermined pitch outside a substantially central λ/4 phase shift portion of the diffraction grating layer and along the direction of the waveguide path, i.e. the resonator direction, wherein the width of the openings along the resonator direction is constant, and the length of the openings in the direction perpendicular to the resonator direction is gradually changed along the direction of the waveguide path respectively resorator direction such as to suppress the occurence of hole burning;
a step of etching portions of the diffraction grating layer exposed in the openings;
a step of peeling-off the photoresist and covering the remaining portion of the diffraction grating layer with a barrier layer having the same composition as the semiconductor substrate, and
a step of forming on the barrier layer an active layer having a smaller energy gap than the semiconductor substrate.

In the invention defined in Claim 17, there is provided a method of producing a semiconductor laser according to Claim 15 or 16, wherein said λ/4 shift portion is formed in substantially the central portion of the diffraction grating layer by shifting the phase of the embedded diffraction grating by λ/4 (λ: wavelength of light), and the width of the embedded diffraction grating is gradually reduced in the direction of the λ/4 shift portion.

In the invention defined in Claim 18, there is provided a method of producing a semiconductor laser according to Claim 15 or 16, wherein said λ/4 shift portion is formed in substantially the central portion of the diffraction grating layer by shifting the phase of the embedded diffraction grating by λ/4 (λ: wavelength of light), and the width of the embedded diffraction grating is gradually increased in the direction of the λ/4 shift portion.

In the invention defined in Claim 19, there is provided a method of producing a semiconductor laser which comprises:
a step of successively forming on a semiconductor substrate an active layer having a smaller energy gap than the semiconductor substrate and a barrier layer having a larger energy gap than the active layer;
a step of forming a heat-resistant film on the barrier layer;
a step of forming first openings in the heat-resistant film wherein the lengths in the direction perpendicular to the waveguide path, i.e. perpendicular to the resonator direction, of the openings are gradually changed along the resonator direction such as to suppress the occurence of hole burning;
a step of forming an diffraction grating layer by crystal growth on the barrier layer exposed in the first openings;
a step of peeling-off the heat-resistant film and forming a photoresist on the diffraction grating layer;
a step of light-exposing and developing the photoresist to thereby form an etching mask having second stripe-like openings which are arranged at a predetermined pitch outside a substantially central λ/4 phase shift portion of the diffraction grating layer and along the direction of the waveguide path respectively resonator direction wherein the width along the resonator direction is constant; and
a step of etching the diffraction grating layer exposed in the second openings.

In the invention defined in Claim 20, there is provided a method of producing a semiconductor laser which comprises:
a step of forming a heat-resistant layer on a semiconductor substrate;
a step of forming in the heat-resistant layer first openings wherein the lengths of the openings in the direction perpendicular to the direction of the waveguide path, i.e. perpendicular to the resonator direction, are gradually changed along the resonator direction such as to suppress the occurence of hole burning;
a step of forming a diffration grating layer by crystal growth on the semiconductor substrate exposed in the first openings;
a step of peeling-off the heat-resistant film and forming a photoresist on the diffraction grating layer;
a step of light-exposing and developing the photoresist to thereby form an etching mask having stripe-like openings which are arranged at a constant pitch outside a substantially central λ/4 phase shift portion of the diffraction grating layer and along the resonator direction wherein the widths of the openings in the direction of the waveguide path respectively resonator direction are constant;
a step of etching the diffraction grating layer exposed in the openings;
a step of peeling-off the photoresist and covering the remaining portion of the diffraction grating layer with a barrier layer having the same composition as the semiconductor substrate; and
a step of forming on the barrier layer an active layer composed of material having a smaller energy gap than the semiconductor substrate.

In the invention defined in Claim 21, there is provided a method of producing a semiconductor laser according to Claim 19 or 20, wherein said λ/4 shift opening portion is formed in substantially the central portion of the diffraction grating layer by shifting the phase of the openings by λ/4 (λ: wavelength of light), and the widths of the openings are gradually reduced in the direction of the λ/4 shift opening portion.

In the invention defined in Claim 22, there is provided a method of producing a semiconductor laser according to Claim 19 or 20, wherein said λ/4 shift opening portion is formed in substantially the central portion of the diffraction grating layer by shifting the phase of the openings by λ/4 (λ: wavelength of light), and the widths of the openings are gradually increased in the direction of the λ/4 shift opening portion.

In the invention defined in Claim 23, there is provided a method of producing a semiconductor laser according to anyone of Claims 11 to 22, wherein the refractive index of the embedded diffraction grating is different from that of the barrier layer.

In the invention defined in Claim 24, there is provided a method of producing a semiconductor laser according to anyone of Claims 11 to 22, wherein the energy gap of the embedded diffraction grating is larger than that of the active layer and smaller than that of the barrier layer.

In drawings:

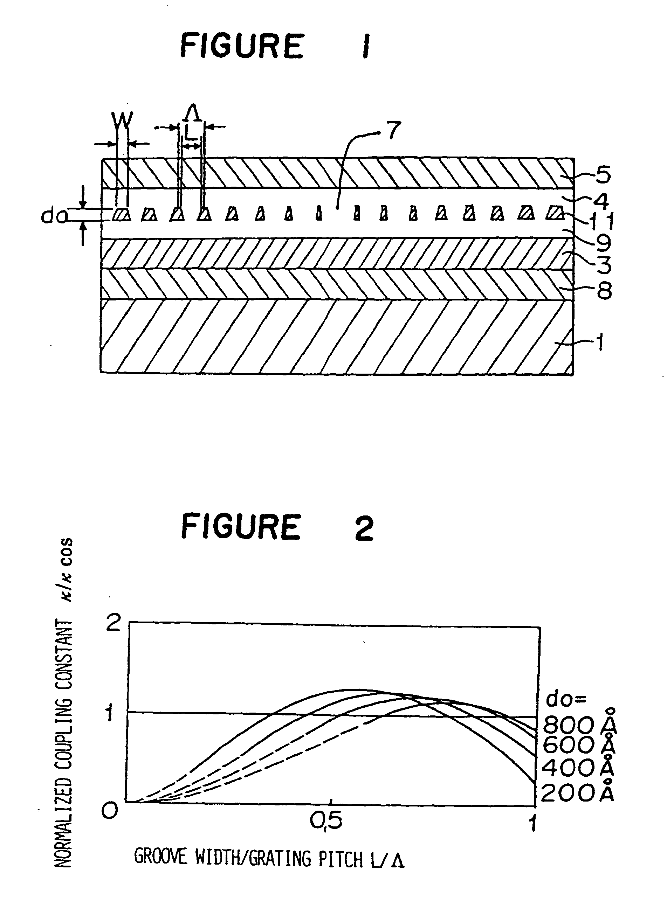

Figure 1 is a cross-sectional view showing an embodiment-of the semiconductor laser according to the present invention;
Figure 2 is a diagram showing a function of the semiconductor laser of the first embodiment of the present invention;

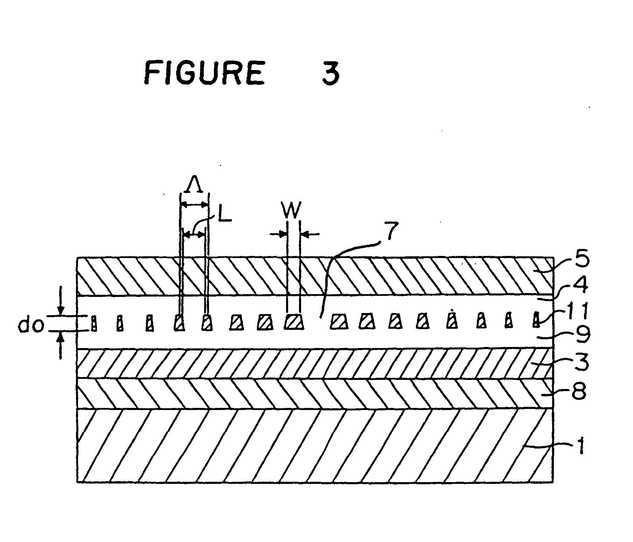

Figure 3 is a cross-sectional view showing another embodiment of the semiconductor laser according to the present invention;

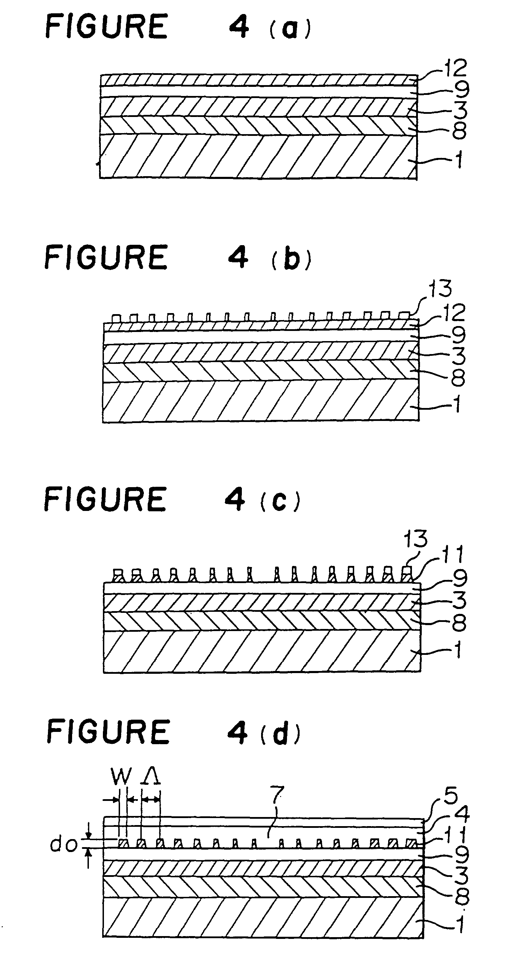

Figures 4a to 4d are cross-sectional views showing steps of producing a semiconductor laser according to an embodiment of the present invention;

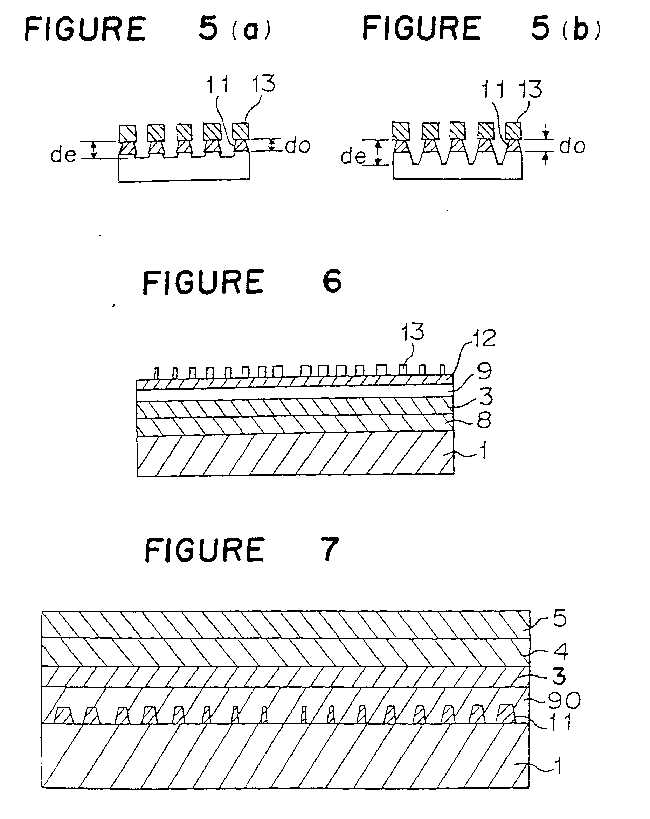

Figures 5a and 5b are cross-sectional views showing how an embedded diffraction grating is formed by the method of producing a semiconductor laser according to an embodiment of the present invention;

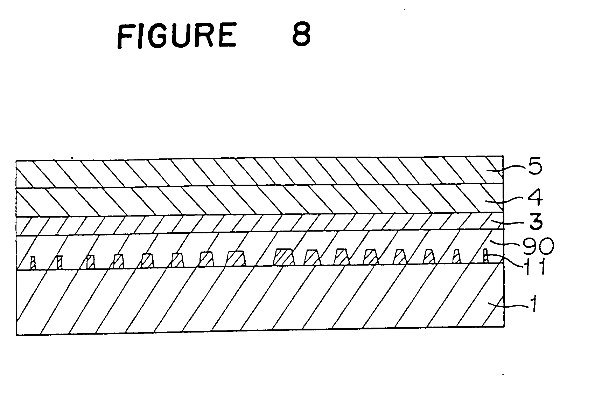

Figure 6 is a cross-sectional view showing another embodiment of the method of producing a semiconductor laser according to the present invention;

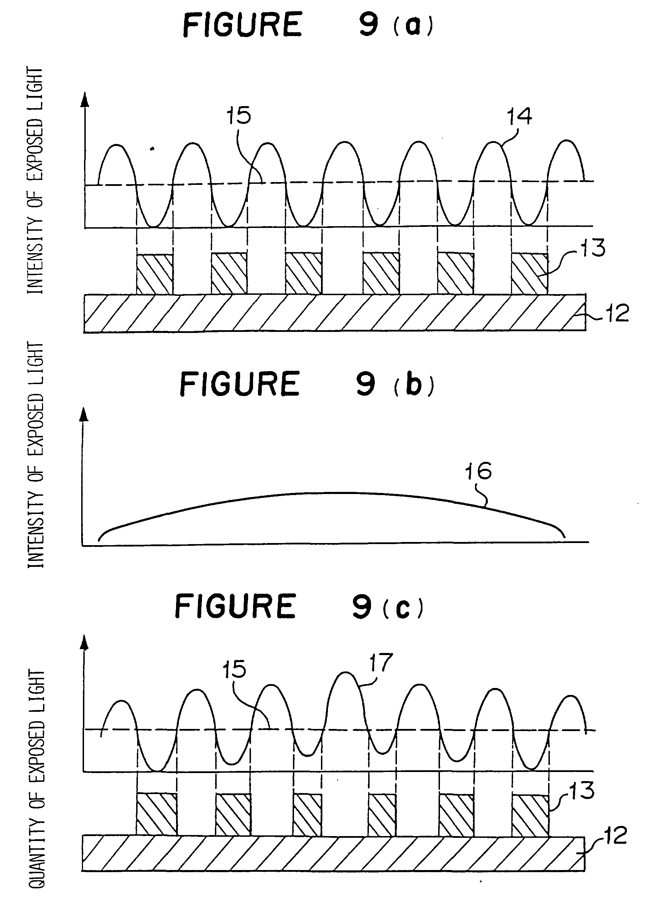

Figure 7 is a cross-sectional view showing another embodiment of the semiconductor laser of the present invention;
Figure 8 is a cross-sectional view showing another embodiment of the semiconductor laser of the present invention;

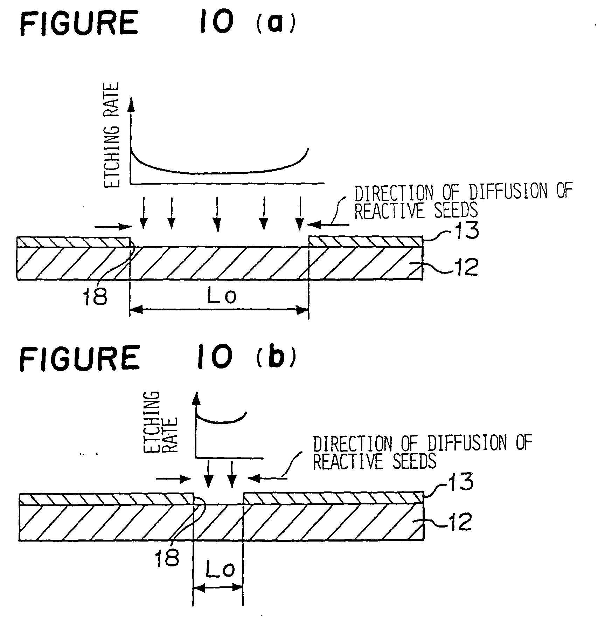

Figures 9a to 9c are diagrams for explaining another embodiment of the method of producing the semiconductor laser of the present invention;

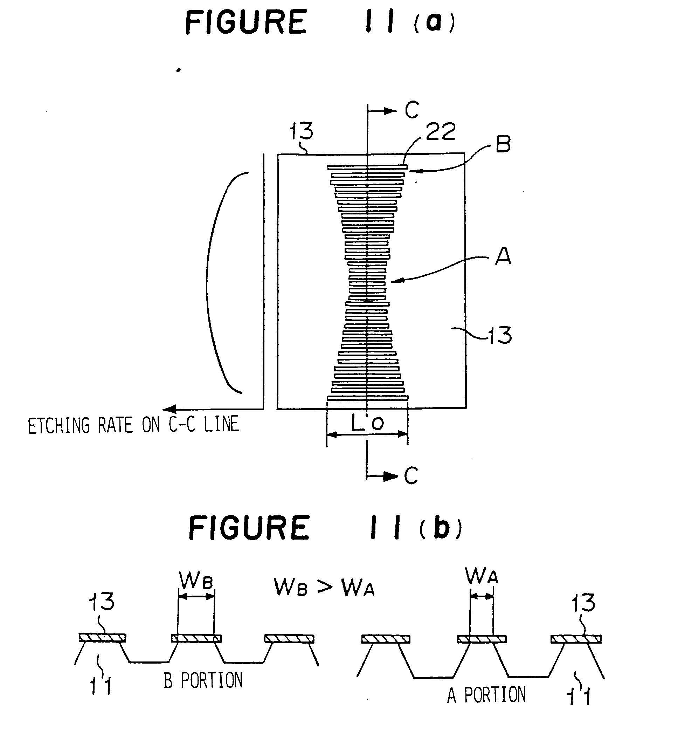

Figures 10a and 10b are cross-sectional views for explaining micro-loading effect;
Figures 11a and 11b are respectively a plan view and a cross-sectional view for explaining another embodiment of the method of producing a semiconductor laser according to the present invention;

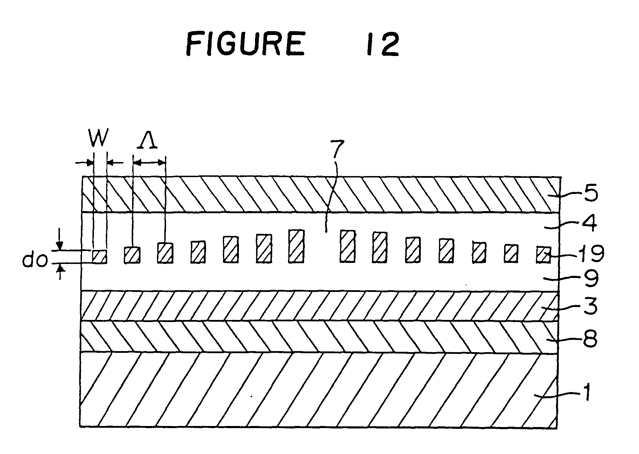

Figure 12 is a cross-sectional view showing another embodiment of the semiconductor laser of the present invention;
Figures 13a to 13e are diagrams explaining another embodiment of the method of producing a semiconductor laser according to the present invention;

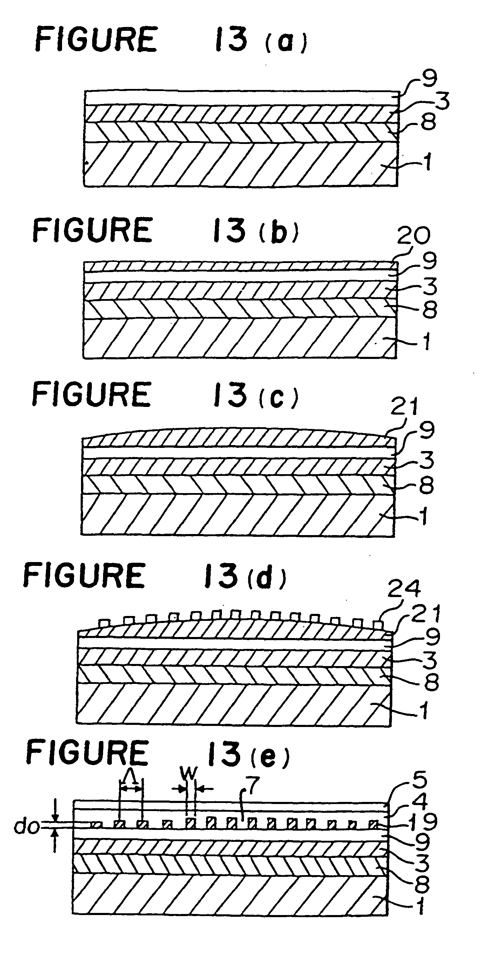

Figures 14a and 14b are respectively a plan view and a cross-sectional view partly omitted which show a mask for crystal growth used for the method of producing a semiconductor laser according to the present invention;

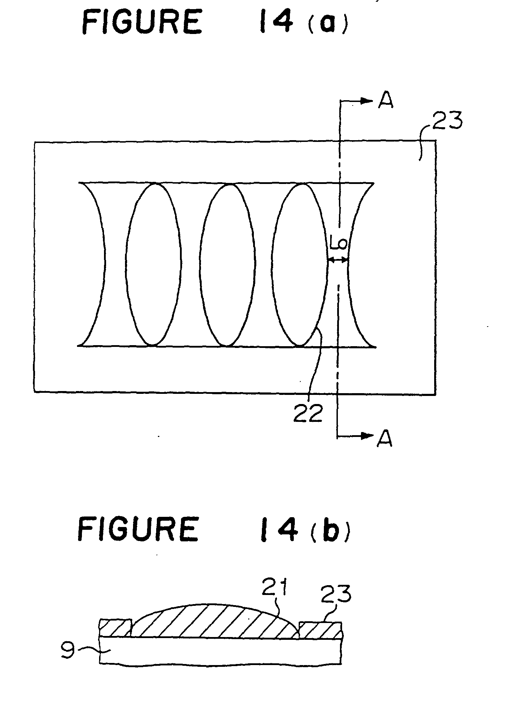

Figure 15 is a cross-sectional view showing another embodiment of the semiconductor laser of the present invention;
Figure 16 is a cross-sectional view showing another embodiment of the semiconductor laser of the present invention;

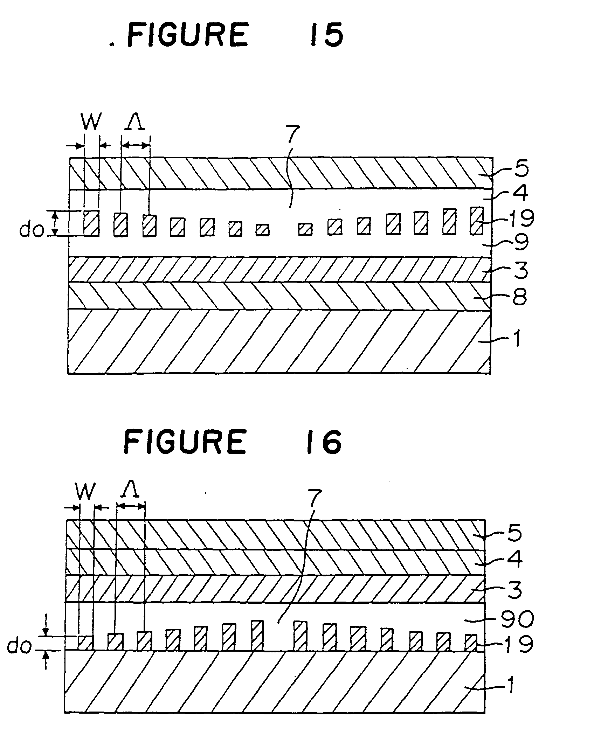

Figure 17 is a cross-sectional view showing another embodiment of the semiconductor laser of the present invention;
Figure 18 is a cross-sectional view showing an example of a conventional semiconductor laser;
Figure. 19 is a cross-sectional view showing another example of a conventional semiconductor laser;
Figure 20 is a diagram showing an intensity of light field at a λ/4 shift portion;
Figure 21 is a cross-sectional view showing an example of a conventional semiconductor laser; and
Figure 22 is a cross-sectional view showing another example of a conventional semiconductor laser.

Preferred embodiments of the present invention will be described with reference to the drawings wherein the same reference numerals designates the same or corresponding parts.

Figure 1 is a cross-sectional view showing an embodiment of the semiconductor laser of the present invention. In Figure 1, the same reference numerals as in Figure 21 designates the same or corresponding parts and description of these parts is omitted. Reference numeral 11 designates an embedded diffraction grating formed of a stripe-like material which is composed of p-InGaAsP. The embedded diffraction grating is so formed that it has a constant pitch Λ and a constat height d₀, however, the width W is gradually reduced in the direction of a λ/4 shift portion 7. In other words, the embedded diffraction grating 11 is so formed that the size of gaps L formed in the grating 11 gradually increases in the direction of the λ/4 shift portion 7.

The embedded diffraction grating 11 can be made of such material that the energy gap is larger than an active layer 3 but smaller than a barrier layer 9, or the refractive index is different from that of the barrier layer 9 and a buffer layer 4 (which has the same composition as the barrier layer 9).

Figure 2 is a diagram showing the relation between a embedded diffraction grating and the reflectance of light disclosed in Journal of Lightwave Technology Vol. 7, No. 12, December, 1989, p2072. In Figure 2, the ordinate represents the reflectance of light in terms of a unit of κ/κ_{cos}. The reflectance κ/κ_{cos} is a function in which the height d₀ of the diffraction grating and the ratio of the gap L of the diffraction grating to the pitch Λ of the diffraction grating are used as parameters.

It is understood from Figure 2 that the reflectance of light can be reduced when the ratio of the gap L of the diffraction grating to the pitch Λ of the diffraction grating is made larger or smaller. Namely, the semiconductor laser shown in Figure 1 is so formed that the pitch Λ and the height d₀ are respectively made constant while the width is gradually reduced in the direction of the λ/4 shift portion 7, with a result that the gap L of the embedded diffraction grating 11 is gradually increased in the direction of the λ/4 shift portion 7.

In conventional techniques, it was difficult to form the p-InP substrate by means of etching. However, in accordance with this embodiment, such problem can be eliminated, and a semiconductor laser having a diffraction grating capable of suppressing the occurrence of hole burning while it can be easily and accurately fabricated, can be obtained.

Semiconductor laser can be modified to have the construction as shown in Figure 3, as easily understood from the explanation with reference to Figure 2. Namely, the same effect as in the embodiment shown in Figure 1 can be obtained by forming a semiconductor laser so that the pitch Λ and the height d₀ are respectively constant while the width W is gradually increased in the direction of the λ/4 shift portion 7, as a result that the dimensions of the gaps L of the embedded diffraction grating 11 is gradually reduced.

An embodiment of the method of producing a semiconductor laser according to the present invention will be described with reference to Figures 4a to 4d.

First, as shown in Figure 4a, a buffer layer 8 composed of p-InP, an active layer 3 of InGaAsP, a barrier layer 9 of n-InP and an embedded diffraction grating layer 12 of n-InGaAsP from which an embedded diffraction grating 11 is formed, are successively formed by a crystal growing method on a p-InP substrate 1.

Then, an etching mask 13 is formed with use of a photoresist or the like in a manner that dimensions of openings of the mask 13 are gradually increased in the direction of a λ/4 shift portion 7 as shown in Figure 4b. In the formation of the etching mask 13 for forming a diffraction grating having a fine pitch, an EB (electron beam) direct patterning method, an interference light exposure method using a holographic technique or an X-ray exposure method can be used. When the EB direct patterning method is used for instance, a positive type photoresist is used and a dose quantity of electron beams is changed whereby the widths of the openings of the etching mask 13 are gradually changed. In order to increase the widths of the openings of the etching mask 13, the dose quantity of electron beams should be increased, and in order to reduce the widths of the openings, the dose quantity of electron beams should be reduced.

Then, the embedded diffraction grating layer 12 on which the etching mask 13 is formed is subjected to an etching treatment. As a result, the embedded diffraction grating 11 wherein portions of the embedded diffraction grating layer 12 corresponding to the openings of the etching mask 13 are removed, can be formed as shown in Figure 4c. After the etching mask 13 has been removed, an upper cladding layer 4 of n-InP and a contact layer 5 of n⁺-InGaAsP are successively formed on the embedded diffraction grating 11 as shown in Figure 4d. Thus, the semiconductor laser with the embedded diffraction grating 11 in which the pitch Λ and the height d₀ are respectively constant while the width W is gradually changed in the direction of the λ/4 shift portion 7 is produced.

In the method of producing the semiconductor laser described above, since the reflectance of light is controlled by the width W of the embedded diffraction grating 11, the height of the embedded diffraction grating 11 is determined by the thickness of the embedded diffraction grating layer 12 and is always constant even though there is scattering in the depth dₑ of etching, as shown in Figures 5a and 5b. Accordingly, it is unnecessary to carefully control an etching quantity as in the conventional techniques, and diffraction grating 11 can be formed easily and accurately.

In order to form the semiconductor laser as shown in Figure 3 wherein the pitch λ and the height d₀ of the embedded diffraction grating 11 are respectively constant while the width W is gradually increased in the direction of the λ/4 shift portion 7 whereby the dimensions of the gaps L of the diffraction grating 11 are gradually reduced, an etching mask 13 as shown in Figure 6 wherein the dimensions of the openings of the etching mask 13 are gradually reduced, can be used.

Material used for the embedded diffraction grating 11 may be such one that the energy gap is larger than that of the active layer 3 and smaller than the barrier layer 9, or the refractive index is different from that of the barrier layer 9 and the buffer layer 4 (which has the same composition as the barrier layer 9).

In the above-mentioned embodiment, the embedded diffraction grating 11 is put between the barrier layer 9 and the buffer layer 4. However, the same effect is obtainable with a semiconductor laser prepared as follows. As shown in Figures 7 and 8, on the p-InP substrate 1, the embedded diffraction grating 11 composed of p-InGaAsP, a barrier layer 90 of p-InP which is the same composition as the p-InP substrate 1, the active layer 3 of InGaAsP, the upper cladding layer 4 of n-InP and the contact layer 5 of n⁺-InGaAsP are successively formed wherein the pitch Λ and the height d₀ of the embedded diffraction grating 11 are respectively constant and the width W is changed in the direction of the λ/4 shift portion 7. In the above-mentioned structure, the embedded diffraction grating 11 may be of such material that the energy gap is larger than that of the active layer 3 but smaller than the barrier layer 90, or the refractive index is different from that of the barrier layer 90.

In the above-mentioned embodiment, the p-InP substrate 1 having an electric conductive property is used. However, in the present invention, a semiconductive InP substrate or an n-InP substrate may be used. Further, another material such as an GaAs series can also be used.

A second embodiment of the present invention will be described.

Instead of the method of producing a semiconductor laser with use of the EB direct patterning method as described in the first embodiment 1, an interference light exposure method is used in this embodiment, which will be described with reference to Figures 9a to 9c.

A positive type photoresist is used for the etching mask 13 shown in Figure 4b, and an interference light exposure method with a sinusoidal wave light exposure pattern) is used to conduct a first light exposure 14 as shown in Figure 9a. Areas irradiated with light having the intensity exceeding a dissolving point 15 in development are dissolved at the time of a developing operation, whereby an etching mask 13 having a uniform shape can be formed as shown in Figure 9a.

A feature of the present invention is to gradually change the width of the embedded diffraction grating 11. Accordingly, the width of the etching mask 13 should be gradually changed. For this purpose, a second light exposure 16 is conducted after the above-mentioned interference light exposure has been conducted. In the second light exposure, the intensity of the light is gradually increased in the direction of the central portion as shown in Figure 9b. The entire quantity of light exposed to the photoresist is shown in Figure 9c which shows a light exposure pattern 17 in which the peak strength of a sinusoidal wave is gradually increased to the central portion, whereby the widths of openings in the etching mask 13 after the developing operation are gradually increased.

As shown in Figure 9b, light exposure can be conducted so that the intensity of light is gradually reduced in the direction of the central portion whereby the widths of openings of the etching mask 13 after the developing operation can be gradually reduced,.

An interference light exposure device is extremely cheaper than an electron beam direct patterning device, and cost for producing products can be remarkably decreased.

In this embodiment, the second light exposure is conducted after the interference light exposure so as to gradually change the intensity of light to be exposed. However, it is possible to conduct light exposure at once if the intensity of light exposure in the interference light exposure has a distribution. In a method of producing a distribution on the intensity of light exposure, a beam splitter which provides a different reflectance at a local area may be put at a predetermined angle in the light path, or a slit may be successively moved to change a time of light exposure, with a result that a distribution on the intensity of exposed light is obtainable.

A third embodiment of the present invention will be described.

In the first and the second embodiments, the width of the diffraction grating is controlled by gradually changing the widths of the openings of the etching mask. In this embodiment, the width of the diffraction grating is controlled by utilizing a micro-loading effect.

First, explanation will be made as to the micro-loading effect with reference to cross-sectional views in Figures 10a and 10b. In Figure 10, reference numeral 13 designates an etching mask, numeral 12 designates an embedded diffraction grating layer and numeral 18 designates an opening portion of the etching mask 13. The exposed portion of the embedded diffraction grating layer 12 of InGaAsP, the exposed portion being at an opening portion 18 of the etching mask 13, is reacted with reactive seeds to be etched. The reactive seeds are consumed at the etching portion, i.e., the exposed portion. Since, the etching reaction does not take place on the etching mask 13, the concentration of the reactive seeds becomes higher than that of the etching portion, whereby the reactive seeds diffuse to the opening portion 18 where the etching reaction takes place.

Accordingly, as shown in Figure 10a, when the length L₀ of the opening portion 18 is large, a rate of etching at a portion near the edge of the opening portion 18, i.e., the edge of the etching mask 13 becomes higher than that the other portion. Further, as shown in Figure 10b, when the length L₀ of the opening portion 18 is smaller, the rate of etching at the opening portion 18 becomes high due to the reactive seeds which diffuse from the etching mask 13. This phenomenon is called the micro-loading effect, which takes place in either wet etching or dry etching. It is sufficient to form the diffraction grating of a semiconductor layer only in the waveguide path. Further, since the width of the waveguide path is at most about 1 µm, the micro-loading effect is easily obtained.

Figures 11a and 11b are respectively a plan view showing a pattern of arrangement of the opening portion 18 of the etching mask 13 and a cross-sectional view taken along a C-C line which shows a state of etching of the guide layer 12 at a peripheral portion B and the central portion A of the opening 18. In Figure 11a, a rate of etching corresponding to each position on the C-C line is shown.

As shown in Figure 11a, the length L₀ of the opening portion 18 becomes small in the direction of the central portion. Accordingly, the rate of etching become large due to the micro-loading effect as locations approach the central portion. As shown in Figure 11b, undercut portions are produced below the etching portion 13. Since the quantity of each of the undercuts becomes large as the etching rate is large, the width W_{A} at the central portion A of the embedded diffraction grating 11 is smaller than the width W_{B} at a peripheral portion B of the grating 11. Since the etching rate becomes large as locations approach from the peripheral portion B to the central portion A, the width of the embedded diffraction grating 11 becomes small in the direction from the peripheral portion B to the central portion A.

In accordance with the method of producing the semiconductor laser in this embodiment, the intervals of the openings 18 of the etching mask 13 in the direction of the waveguide path can be made constant. Accordingly, it is easy to form the etching mask 13.

A fourth embodiment of the present invention will be described.

In the first to the third embodiments, the reflectance of light is changed by controlling the width of the embedded diffraction grating .

In the fourth embodiment, however, the reflectance of light is changed by adjusting the height of the embedded diffraction grating.

Figure 12 is a cross-sectional view showing the structure of the semiconductor laser according to the fourth embodiment wherein the same reference numerals as in Figure 1 designate the same or corresponding parts and description of these parts is omitted.

In Figure 12, reference numeral 19 designates an embedded diffraction grating composed of n-InGaAsP, which is so formed that the pitch Λ and width W are constant, and the height do is gradually increased in the direction of the λ/4 shift portion 7.

It is understood from Figure 2 that for instance, when the ratio of the distance L/the pitch of the diffraction grating is 0.5, the reflectance becomes small as the height do is higher. Accordingly, in the structure of the semiconductor laser shown in Figure 12, the reflectance of light at the central portio of the semiconductor laser is decreased. Accordingly, the occurrence of hole burning can be suppressed even when an output of light is increased.

Further, the height of the embedded diffraction grating 19 is determined by controlling the thickness of the layer when it is formed by a crystal growth method.

In the method according to this embodiment, the control of the thickness of the layer formed by the crystal-growth can be extremely accurate, and the performance of the semiconductor laser produced can be remarkably increased.

Figures 13a to 13e are respectively cross-sectional views showing steps of producing the semiconductor laser shown in Figure 12, and Figure 14a is a plan view showing a mask for crystal growth.

First, as shown in Figure 13a, the buffer layer 8 of p-InP, the active layer 3 of InGaAsP and the barrier layer 9 of n-InP are successively formed by crystal growth on the p-InP substrate 1.

Prior to the crystal growth formation of an embedded diffraction grating layer 21 of n-InGaAsP, a SiO₂ film 20 is formed on the barrier layer 9. Then, the SiO₂ film 20 is etched with use of a photoresist or the like, whereby a mask 23 for crystal growth which has openings arranged in a pattern wherein widths between adjacent openings 22 are gradually narrowed in the direction of the central portion of the waveguide path (A-A direction), is formed as shown in Figure 14a.

For the formation of the openings 22, an electron beam direct patterning method with use of a photoresist, an interference light exposure method by utilizing a holographic technique or an X-ray exposure method can be used.

After the mask for crystal growth 23 has been formed with the SiO₂ film 20, the photoresist is peeled off, followed by the forming the n-InGaAsP layer by using a crystal growth method whereby the embedded diffraction grating layer 21 of n-InGaAsP is formed.

Since there occurs no crystal growth on the mask for crystal growth 23, the concentration of crystal seeds becomes high at a central portion where the distance between adjacent openings of the mask 23 is small, whereby the rate of crystal growth at the central portion of the openings 22 becomes high. As a result, the height of the diffraction grating layer 21 in cross-sectional view taken along a line A-A is increased in the direction from its each edge portion to the central portion as shown in Figure 14b. Thus, the embedded diffraction grating layer 21 whose height is increased in the direction of the central portion as shown in Figure 13c is formed.

Then, the etching mask formed of a photoresist 24, which has stripe-like openings arranged with a constant pitch and having a constant width in parallel to each other in the direction of the waveguide path, is formed by using an EB direct patterning method, an interference light exposure method utilizing a holographic technique or an X-ray exposure method, followed by etching the embedded diffraction grating layer 21 as shown in Figure 13d. Then, the photoresist 24 is peeled off. Thereafter, the upper cladding layer 4 of InP and the contact layer 5 of InGaAsP are successively formed as shown in Figure 13e, whereby a semiconductor laser having the diffraction grating 19 whose pitch Λ and width W are respectively constant while the height d₀ is gradually increased in the direction of the λ/4 shift portion 7, is produced.

As is understood from description concerning Figure 2, the same effect is obtainable even by a semiconductor laser produced in such a manner that the pitch Λ and the width W are respectively constant and the height d₀ is gradually decreased in the direction of λ/4 shift portion 7, as shown in Figure 15.

As material used for the embedded diffraction grating 19, it is sufficient that the energy gap is larger than that of the active layer 3 but is smaller than that of the barrier layer 9, or the refractive index is different from the that of the barrier layer 9 and the buffer layer 4 (which has the same composition as the barrier layer 9).

In this embodiment, the embedded diffraction grating 19 is put between the barrier layer 9 and the buffer layer 4. However, the same effect can be obtained even by a semiconductor laser which can be prepared as follows.

As shown in Figures 16 and 17, on the p-InP substrate 1, the embedded diffraction grating 19 of p-InGaAsP, a barrier layer 90 of p-InP which has the same composition as the p-InP substrate 1, the active layer 3 of InGaAsP, the upper cladding layer 4 of n-InP and the contact layer 5 of n⁺-InGaAsP are successively formed wherein the embedded diffraction grating 19 has a constant pitch Λ, a constant width W and a height d₀ which gradually increases respectively decreases in the direction of the λ/4 shift portion 7. In this structure of the semiconductor laser, it is sufficient for the embedded diffraction grating 19 that the energy gap is larger than that of the active layer 3 but smaller than the barrier layer 90, or the refractive index is different from that of the barrier layer 90.

Further, in this embodiment, the p-InP substrate 1 having an electric conductive property is used. However, a semiconductive InP substrate or a semiconductive n-InP substrate may be used. Further, another material of a GaAs series or the like can also be used.

In accordance with the inventions defined in Claims 1, 2, 11 and 12, there is obtainable a semiconductor laser having a stripe-like embedded diffraction grating capable of suppressing the occurrence of hole burning by gradually changing the width of the diffraction grating along the direction of the waveguide path, i.e. along the resonator direction. Conventionally, it was difficult to form such diffraction grating by etching a semiconductor substrate. However, according to the claimed inventions, the diffraction grating can easily be produced with high precision.

According to the inventions defined in Claims 3, 4, 7, 8, 9, 10, 17, 18, 21, 22, 23 and 24, there is obtainable a semiconductor laser of high performance and a stable mode at the time of a high output of light and capable of suppressing hole burning.

According to the inventions defined in Claims 5, 6, 15, 16, 19 and 20, there is obtainable a semiconductor laser having a stripe-like embedded diffraction grating capable of suppressing the occurrence of hole burning by gradually changing the height of the diffraction grating along the direction of the waveguide path, i.e. along the resonator direction. Conventionally, it was difficult to form such diffraction grating by etching a semiconductor substrate. Further, in the present inventions, the diffraction grating can be easily and formed with high precision.

In accordance with the inventions defined in Claims 15, 16, 19 and 20, the widths of the openings of an etching mask can be formed constant. Accordingly, it is easy to form the etching mask.

In accordance with the invention defined in Claim 13, a dose quantity of electron beams is gradually changed along the direction of the waveguide path, i.e. along the resonator direction, whereby stripe-like openings can be formed in a photoresist in such a manner that the openings are arranged with a constant pitch along the resonator direction and the widths of the openings are gradually changed along the resonator direction.

In accordance with the invention defined in Claim 14, exposure of interference light for irradiating light having a sinusoidal wave-pattern in light intensity and exposure of light for irradiating light having a pattern in light intensity in which the light intensity is gradually changed along the direction of the waveguide path, i.e. along the resonator direction, are superposed, whereby stripe-like openings can be formed with less expense in a photoresist in such a manner that the openings are arranged with a constant pitch along the resonator direction and the widths of the openings are gradually changed in the resonator direction.

In accordance with the inventions defined in Claims 19 and 20, first openings are formed in a heat-resistant layer wherein the lengths of the openings in the direction perpendicular to the direction of the waveguide path, i.e. perpendicular to the resonator direction, are gradually changed along the resonator direction, and an embedded diffraction grating layer is formed by crystal growth on a barrier layer respectively semiconductor substrate exposed in the first openings, whereby the embedded diffraction grating layer in which the height is gradually changed in the direction of the waveguide path, i.e. the resonator direction can be formed with high accuracy, with the result that a semiconductor laser of high performance can be obtained.

## Claims

1. A semiconductor laser which comprises:
a semiconductor substrate (1);
an active layer (3) formed above the semiconductor substrate (1), which has a smaller energy gap than the semiconductor substrate;
a barrier layer (9) formed on the active layer, which has a larger energy gap than the active layer; and
an embedded diffraction grating (11) which comprises a λ/4 phase shift portion (7) substantially in the central portion thereof and which is composed of stripes, each having a width along the resonator direction, a length in the direction perpendicular to the resonator direction, and a height, and which is embedded between the barrier layer (9) and a cladding layer (4) having the same composition as the barrier layer so as to extend with a parallel arrangement at a constant pitch outside the λ/4 phase shift portion (7) and along the resonator direction, wherein the height of the stripes is constant and the width of the stripes outside the λ/4 phase shift portion (7) is gradually changed along the resonator direction such as to suppress the occurence of hole burning.

2. A semiconductor laser which comprises:
a semiconductor substrate (1);
an embedded diffraction grating (11) which comprises a λ/4 phase shift portion (7) substantially in the central portion thereof and which is composed of stripes, each having a width along the resonator direction, a length in the direction perpendicular to the resonator direction, and a height, and which is embedded between the semiconductor substrate (1) and a barrier layer (90) having the same composition as the semiconductor substrate so as to extend with a parallel arrangement at a constant pitch outside the λ/4 phase shift portion (7) and along the resonator direction, wherein the height of the stripes is constant and the width of the stripes outside the λ/4 phase shift portion (7) is gradually changed along the resonator direction such as to suppress the occurence of hole burning; and
an active layer (3) which is formed on the barrier layer (90) and which is composed of material having a smaller energy gap than the semiconductor substrate.

3. A semiconductor laser according to Claim 1 or 2, wherein said λ/4 shift portion (7) is formed in substantially the central portion of the embedded diffraction grating (11) by shifting the phase of the embedded diffraction grating (11) by λ/4 (λ: wavelength of light), and the width of the embedded diffraction grating is gradually reduced in the direction of the λ/4 shift portion.

4. A semiconductor laser according to Claim 1 or 2, wherein said λ/4 shift portion (7) is formed in substantially the central portion of the embedded diffraction grating (11) by shifting the phase of the embedded diffraction grating (11) by λ/4 (λ: wavelength of light), and the width of the embedded diffraction grating is gradually increased in the direction of the λ/4 shift portion.

5. A semiconductor laser which comprises:
a semiconductor substrate (1);
an active layer (3) formed above the semiconductor substrate, which has a smaller energy gap than the semiconductor substrate;
a barrier layer (9) formed on the active layer, which has a larger energy gap than the active layer; and
an embedded diffraction grating (19) which comprises a λ/4 phase shift portion (7) substantially in the central portion thereof and which is composed of stripes, each having a width along the resonator direction, a length in the direction perpendicular to the resonator direction, and a height, and which is embedded between the barrier layer (9) and a cladding layer (4) having the same composition as the barrier layer so as to extend with a parallel arrangement at a constant pitch outside the λ/4 phase shift portion (7) and along the resonator direction, wherein the width of the stripes is constant and the height of the stripes is changed along the resonator direction such as to suppress the occurence of hole burning.

6. A semiconductor laser which comprises:
a semiconductor substrate (1);
an embedded diffraction grating (19) which comprises a λ/4 phase shift portion (7) substantially in the central portion thereof and which is composed of stripes, each having a width along the resonator direction, a length in the direction perpendicular to the resonator direction, and a height, and which is embedded between the semiconductor substrate (1) and a barrier layer (90) having the same composition as the semiconductor substrate so as to extend with a parallel arrangement at a constant pitch outside the λ/4 phase shift portion (7) and along the resonator, wherein the width of the stripes is constant and the height of the stripes is changed along the resonator direction such as to suppress the occurence of hole burning, and
an active layer (3) which is formed on the barrier layer (90) and which is composed of material having a smaller energy gap than the semiconductor substrate.

7. A semiconductor laser according to Claim 5 or 6, wherein said λ/4 shift portion (7) is formed in substantially the central portion of the embedded diffraction grating (19) by shifting the phase of the embedded diffraction grating (19) by λ/4 (λ: wavelength of light), and the height of the embedded diffraction grating is gradually reduced in the direction of the λ/4 shift portion.

8. A semiconductor laser according to Claim 5 or 6, wherein said λ/4 shift portion (7) is formed in substantially the central portion of the embedded diffraction grating (19) by shifting the phase of the embedded diffraction grating (19) by λ/4 (λ: wavelength of light), and the height of the embedded diffraction grating is gradually increased in the direction of the λ/4 shift portion.

9. A semiconductor laser according to anyone of Claims 1 to 8, wherein the refractive index of the embedded diffraction grating (11;19) is different from that of the barrier layer (9;90).

10. A semiconductor laser according to anyone of Claims 1 to 8, wherein the energy gap of the embedded diffraction grating (11;19) is larger than that of the active layer (3) and smaller than that of the barrier layer (9;90).

11. A method of producing a semiconductor laser which comprises:
a step of successively forming on a semiconductor substrate (1) an active layer (3) having a smaller energy gap than the semiconductor substrate, a barrier layer (9) having a larger energy gap than the active layer and an diffraction grating layer (12);
a step of forming a photoresist on the diffraction grating layer;
a step (14;14,16) of light-exposing and developing the photoresist to thereby form an etching mask (13) having stripe-like openings which are arranged at a predetermined pitch outside a substantially central λ/4 phase shift portion (7) of the diffraction grating layer (12) and along the resonator direction wherein the widths of the openings are gradually changed along the resonator direction such as to suppress the occurence of hole burning, and
a step of etching portions of the diffraction grating layer (12) exposed in the openings.

12. A method of producing a semiconductor laser which comprises:
a step of forming an diffraction grating layer (12) on a semiconductor substrate (1);
a step of forming a photoresist on the diffraction grating layer (12);
a step (14;14,16) of light-exposing and developing the photoresist to thereby form an etching mask (13) having stripe-like openings which are arranged at a predetermined pitch outside a substantially central λ/4 phase shift portion (7) of the diffraction grating layer (12) and along the resonator direction wherein the widths of the openings are gradually changed along the resonator direction such as to suppress the occurence of hole burning;
a step of etching portions of the diffraction grating layer (12) exposed in the openings;
a step of covering the diffraction grating layer with a barrier layer (90) having the same composition as the semiconductor substrate, and
a step of forming on the barrier layer (90) an active layer (3) having a smaller energy gap than the semiconductor substrate.

13. A method of producing a semiconductor laser which comprises:
a step of forming an diffraction grating layer (12) on a semiconductor substrate (1);
a step of forming a photoresist on the diffraction grating layer (12);
a step of conducting an electron beam exposure of the photoresist by gradually changing a dose quantity of electron beams along the resonator direction to thereby form an etching mask having stripe-like openings which are arranged at a predetermined pitch outside a substantially central λ/4 phase shift portion (7) of the diffraction grating layer (12) and along the resonator direction wherein the widths of the openings are gradually changed along the resonator direction such as to suppress the occurence of hole burning;
a step of etching portions of the diffraction grating layer (12) exposed in the openings;
a step of covering the diffraction grating layer with a barrier layer (90) having the same composition as the semiconductor substrate; and
a step of forming on the barrier layer (90) an active layer (3) having a smaller energy gap than the semiconductor substrate.

14. A method of producing a semiconductor laser according to Claim 11 or 12, wherein light exposure (14,16) is conducted by superposing a first light exposure (14) using an interference light exposure method for irradiating light having a sinusoidal wave-pattern of light intensity, on a second light exposure (16) for irradiating light having a pattern of light intensity in which the light intensity is gradually changed along the resonator direction.

15. A method of producing a semiconductor laser which comprises:
a step of successively forming on a semiconductor substrate (1) an active layer (3) having a smaller energy gap than the semiconductor substrate, a barrier layer (9) having a larger energy gap than the active layer and an diffraction grating layer (12);
a step of forming a photoresist on the diffraction grating layer (12);
a step of light-exposing and developing the photoresist to thereby form an etching mask (13) having stripe-like openings (18) which are arranged at a predetermined pitch outside a substantially central λ/4 phase shift portion (7) of the diffraction grating layer (12) and along the resonator direction wherein the width of the openings (18) along the resonator direction is constant, and the length of the openings (18) in the direction perpendicular to the resonator direction is gradually changed along the resonator direction such as to suppress the occurence of hole burning, and
a step of etching portions of the diffraction grating layer (12) exposed in the openings (18).

16. A method of producing a semiconductor laser which comprises:
a step of forming an diffraction grating layer (12) on a semiconductor substrate (1);
a step of forming a photoresist on the diffraction grating layer (12);
a step of light-exposing and developing the photoresist to thereby form an etching mask (13) having stripe-like openings which are arranged at a predetermined pitch outside a substantially central λ/4 phase shift portion (7) of the diffraction grating layer (12) and along the resonator direction wherein the width of the openings along the resonator direction is constant, and the length of the openings in the direction perpendicular to the resonator direction is gradually changed along the resonator direction such as to suppress the occurence of hole burning;
a step of etching portions of the diffraction grating layer (12) exposed in the openings (18);
a step of peeling-off the photoresist and covering the remaining portion of the diffraction grating layer with a barrier layer (90) having the same composition as the semiconductor substrate, and
a step of forming on the barrier layer (90) an active layer (3) having a smaller energy gap than the semiconductor substrate.

17. A method of producing a semiconductor laser according to Claim 15 or 16, wherein said λ/4 shift portion (7) is formed in substantially the central portion of the diffraction grating layer (12) by shifting the phase of the embedded diffraction grating (11) by λ/4 (λ: wavelength of light), and the width of the embedded diffraction grating is gradually reduced in the direction of the λ/4 shift portion.

18. A method of producing a semiconductor laser according to Claim 15 or 16, wherein said λ/4 shift portion (7) is formed in substantially the central portion of the diffraction grating layer (12) by shifting the phase of the embedded diffraction grating (11) by λ/4 (λ: wavelength of light), and the width of the embedded diffraction grating is gradually increased in the direction of the λ/4 shift portion.

19. A method of producing a semiconductor laser which comprises:
a step of successively forming on a semiconductor substrate (1) an active layer (3) having a smaller energy gap than the semiconductor substrate (1) and a barrier layer (9) having a larger energy gap than the active layer;
a step of forming a heat-resistant film (20) on the barrier layer (9);
a step of forming first openings (22) in the heatresistant film (20) wherein the lengths in the direction perpendicular to the resonator direction of the openings (22) are gradually changed along the resonator direction such as to suppress the occurence of hole burning
a step of forming an diffraction grating layer (21) by crystal growth on the barrier layer (9) exposed in the first openings (22);
a step of peeling-off the heat-resistant film (20) and forming a photoresist (24) on the diffraction grating layer (21);
a step of light-exposing and developing the photoresist (24) to thereby form an etching mask having second stripe-like openings which are arranged at a predetermined pitch outside a substantially central λ/4 phase shift portion (7) of the diffraction grating layer (21) and along the resonator direction wherein the width along the resonator direction is constant; and
a step of etching the diffraction grating layer (21) exposed in the second openings.

20. A method of producing a semiconductor laser which comprises:
a step of forming a heat-resistant layer (20) on a semiconductor substrate (1);
a step of forming in the heat-resistant layer (20) first openings (22) wherein the lengths of the openings (22) in the direction perpendicular to the resonator direction are gradually changed along the resonator direction such as to suppress the occurence of hole burning;
a step of forming a diffraction grating layer (21) by crystal growth on the semiconductor substrate (1) exposed in the first openings (22);
a step of peeling-off the heat-resistant film (20) and forming a photoresist (24) on the diffraction grating layer (21);
a step of light-exposing and developing the photoresist (24) to thereby form an etching mask having stripe-like openings which are arranged at a constant pitch outside a substantially central λ/4 phase shift portion (7) of the diffraction grating layer (21) and along the resonator direction wherein the widths of the openings along the resonator direction are constant;
a step of etching the diffraction grating layer (21) exposed in the openings;
a step of peeling-off the photoresist (24) and covering the remaining portion of the diffraction grating layer (21) with a barrier layer (90) having the same composition as the semiconductor substrate; and
a step of forming on the barrier layer an active layer (3) composed of material having a smaller energy gap than the semiconductor substrate.

21. A method of producing a semiconductor laser according to Claim 19 or 20, wherein said λ/4 shift opening portion (7) is formed in substantially the central portion of the diffraction grating layer (21) by shifting the phase of the openings by λ/4 (λ: wavelength of light), and the widths of the openings are gradually reduced in the direction of the λ/4 shift opening portion.

22. A method of producing a semiconductor laser according to Claim 19 or 20, wherein said λ/4 shift opening portion (7) is formed in substantially the central portion of the diffraction grating layer (21) by shifting the phase of the openings by λ/4 (λ: wavelength of light), and the widths of the openings are gradually increased in the direction of the λ/4 shift opening portion.

23. A method of producing a semiconductor laser according to anyone of Claims 11 to 22, wherein the refractive index of the embedded diffraction grating (11;19) is different from that of the barrier layer (9;90).

24. A method of producing a semiconductor laser according to anyone of Claims 11 to 22, wherein the energy gap of the embedded diffraction grating (11;19) is larger than that of the active layer (3) and smaller than that of the barrier layer (9;90).

## Patentansprüche

1. Ein Halbleiterlaser, der aufweist:
ein Halbleitersubstrat (1);
eine über dem Halbleitersubstrat (1) ausgebildete aktive Schicht (3), die eine kleinere Energielücke besitzt als das Halbleitersubstrat;
eine auf der aktiven Schicht ausgebildete Barrierenschicht (9), die eine größere Energielücke besitzt als die aktive Schicht; und
ein eingebettetes Beugungsgitter (11), das einen λ/4-Phasenverschiebungsbereich (7) im wesentlichen in seinem zentralen Bereich aufweist und das aus Streifen besteht, wobei jeder eine Breite entlang der Resonatorrichtung, eine Länge in der Richtung senkrecht zu der Resonatorrichtung und eine Höhe besitzt, und das zwischen der Barrierenschicht (9) und einer Überzugsschicht (4) eingebettet ist, die dieselbe Zusammensetzung besitzt wie die Barrierenschicht, um sich so mit einer parallelen Anordnung mit einer konstanten Ganghöhe außerhalb des λ/4-Phasenverschiebungsbereiches (7) und entlang der Resonatorrichtung zu erstrecken, wobei die Höhe der Streifen konstant ist und die Breite der Streifen sich außerhalb des λ/4-Phasenverschiebungsbereiches (7) entlang der Resonatorrichtung allmählich ändert, um so das Auftreten von Lochbrennen zu unterdrücken.

2. Ein Halbleiterlaser, der aufweist:
ein Halbleitersubstrat (1);
ein eingebettetes Beugungsgitter (11), das einen λ/4-Phasenverschiebungsbereich (7) im wesentlichen in seinem zentralen Bereich aufweist und das aus Streifen besteht, wobei jeder eine Breite entlang der Resonatorrichtung, eine Länge in der Richtung senkrecht zu der Resonatorrichtung und eine Höhe besitzt, und das zwischen dem Halbleitersubstrat (1) und einer Barrierenschicht (90) eingebettet ist, die dieselbe Zusammensetzung besitzt wie das Halbleitersubstrat, um sich so mit einer parallelen Anordnung mit einer konstanten Ganghöhe außerhalb des λ/4-Phasenverschiebungsbereiches (7) und entlang der Resonatorrichtung zu erstrecken, wobei die Höhe der Streifen konstant ist und die Breite der Streifen sich außerhalb des λ/4-Phasenverschiebungsbereiches (7) entlang der Resonatorrichtung allmählich ändert, um so das Auftreten von Lochbrennen zu unterdrücken; und
eine aktive Schicht (3), die auf der Barrierenschicht (90) ausgebildet ist und die aus einem Material mit einer kleineren Energielücke als das Halbleitersubstrat besteht.

3. Ein Halbleiterlaser gemäß Anspruch 1 oder 2, in dem der λ/4-Verschiebungsbereich (7) im wesentlichen im zentralen Bereich des eingebetteten Beugungsgitters (11) mittels Verschieben der Phase des eingebetteten Beugungsgitters (11) um λ/4 (λ: Wellenlänge des Lichts) ausgebildet ist und sich die Breite des eingebetteten Beugungsgitters in der Richtung des λ/4-Verschiebungsbereiches allmählich verringert.

4. Ein Halbleiterlaser gemäß Anspruch 1 oder 2, in dem der λ/4-Verschiebungsbereich (7) im wesentlichen im zentralen Bereich des eingebetteten Beugungsgitters (11) mittels Verschieben der Phase des eingebetteten Beugungsgitters (11) um λ/4 (λ: Wellenlänge des Lichts) ausgebildet ist und sich die Breite des eingebetteten Beugungsgitters in der Richtung des λ/4-Verschiebungsbereiches allmählich vergrößert.

5. Ein Halbleiterlaser, der aufweist:
ein Halbleitersubstrat (1);
eine über dem Halbleitersubstrat ausgebildete aktive Schicht (3), die eine kleinere Energielücke besitzt als das Halbleitersubstrat;
eine auf der aktiven Schicht ausgebildete Barrierenschicht (9), die eine größere Energielücke besitzt als die aktive Schicht; und
ein eingebettetes Beugungsgitter (19), das einen λ/4-Phasenverschiebungsbereich (7) im wesentlichen in seinem zentralen Bereich aufweist und das aus Streifen besteht, wobei jeder eine Breite entlang der Resonatorrichtung, eine Länge in der Richtung senkrecht zu der Resonatorrichtung und eine Höhe besitzt, und das zwischen der Barrierenschicht (9) und einer Überzugsschicht (4) eingebettet ist, die dieselbe Zusammensetzung besitzt wie die Barrierenschicht, um sich so mit einer parallelen Anordnung mit einer konstanten Ganghöhe außerhalb des λ/4-Phasenverschiebungsbereiches (7) und entlang der Resonatorrichtung zu erstrecken, wobei die Breite der Streifen konstant ist und die Höhe der Streifen sich entlang der Resonatorrichtung ändert, um so das Auftreten von Lochbrennen zu unterdrücken.

6. Ein Halbleiterlaser, der aufweist:
ein Halbleitersubstrat (1);
ein eingebettetes Beugungsgitter (19), das einen λ/4-Phasenverschiebungsbereich (7) im wesentlichen in seinem zentralen Bereich aufweist und das aus Streifen besteht, wobei jeder eine Breite entlang der Resonatorrichtung, eine Länge in der Richtung senkrecht zu der Resonatorrichtung und eine Höhe besitzt, und das zwischen dem Halbleitersubstrat (1) und einer Barrierenschicht (90) eingebettet ist, die dieselbe Zusammensetzung besitzt wie das Halbleitersubstrat, um sich so mit einer parallelen Anordnung mit einer konstanten Ganghöhe außerhalb des λ/4-Phasenverschiebungsbereiches (7) und entlang der Resonatorrichtung zu erstrecken, wobei die Breite der Streifen konstant ist und die Höhe der Streifen sich entlang der Resonatorrichtung ändert, um so das Auftreten von Lochbrennen zu unterdrücken; und
eine aktive Schicht (3), die auf der Barrierenschicht (90) ausgebildet ist und die aus einem Material mit einer kleineren Energielücke als das Halbleitersubstrat besteht.

7. Ein Halbleiterlaser gemäß Anspruch 5 oder 6, in dem der λ/4-Verschiebungsbereich (7) im wesentlichen im zentralen Bereich des eingebetteten Beugungsgitters (19) mittels Verschieben der Phase des eingebetteten Beugungsgitters (19) um λ/4 (λ: Wellenlänge des Lichts) ausgebildet ist und sich die Höhe des eingebetteten Beugungsgitters in der Richtung des λ/4-Verschiebungsbereiches allmählich verringert.

8. Ein Halbleiterlaser gemäß Anspruch 5 oder 6, in dem der λ/4-Verschiebungsbereich (7) im wesentlichen im zentralen Bereich des eingebetteten Beugungsgitters (19) mittels Verschieben der Phase des eingebetteten Beugungsgitters (19) um λ/4 (λ: Wellenlänge des Lichts) ausgebildet ist und sich die Höhe des eingebetteten Beugungsgitters in der Richtung des λ/4-Verschiebungsbereiches allmählich vergrößert.

9. Ein Halbleiterlaser gemäß irgendeinem der Ansprüche 1 bis 8, in dem der Brechungsindex des eingebetteten Beugungsgitters (11; 19) verschieden vom dem der Barrierenschicht (9; 90) ist.

10. Ein Halbleiterlaser gemäß irgendeinem der Ansprüche 1 bis 8, in dem die Energielücke des eingebetteten Beugungsgitters (11; 19) größer ist als jene der aktiven Schicht (3) und kleiner als jene der Barrierenschicht (9; 90).

11. Ein Verfahren zum Herstellen eines Halbleiterlasers, das aufweist:
einen Schritt des nacheinander Ausbildens auf einem Halbleitersubstrat (1) einer aktiven Schicht (3), die eine kleinere Energielücke besitzt als das Halbleitersubstrat, einer Barrierenschicht (9), die eine größere Energielücke besitzt als die aktive Schicht, und einer Beugungsgitterschicht (12);
einen Schritt des Ausbildens eines Photolackes auf der Beugungsgitterschicht;
einen Schritt (14; 14, 16) des Licht-Aussetzens und Entwickelns des Photolackes, um dadurch eine Ätzmaske (13) mit streifenartigen Öffnungen zu bilden, die mit einer vorbestimmten Ganghöhe außerhalb eines im wesentlichen zentralen λ/4-Phasenverschiebungsbereiches (7) der Beugungsgitterschicht (12) und entlang der Richtung der Resonatorrichtung angeordnet sind, wobei die Breiten der Öffnungen sich entlang der Resonatorrichtung allmählich ändern, um so das Auftreten von Lochbrennen zu unterdrücken, und
einen Schritt des Ätzens von in den Öffnungen freiliegenden Bereichen der Beugungsgitterschicht (12).

12. Ein Verfahren zum Herstellen eines Halbleiterlasers, das aufweist:
einen Schritt des Ausbildens einer Beugungsgitterschicht (12) auf einem Halbleitersubstrat (1);
einen Schritt des Ausbildens eines Photolackes auf der Beugungsgitterschicht (12);
einen Schritt (14; 14, 16) des Licht-Aussetzens und Entwickelns des Photolackes, um dadurch eine Ätzmaske (13) mit streifenartigen Öffnungen zu bilden, die mit einer vorbestimmten Ganghöhe außerhalb eines im wesentlichen zentralen λ/4-Phasenverschiebungsbereiches (7) der Beugungsgitterschicht (12) und entlang der Resonatorrichtung angeordnet sind, wobei die Breiten der Öffnungen sich entlang der Resonatorrichtung allmählich ändern, um so das Auftreten von Lochbrennen zu unterdrücken;
einen Schritt des Ätzens von in den Öffnungen freiliegenden Bereichen der Beugungsgitterschicht (12);
einen Schritt des Bedeckens der Beugungsgitterschicht mit einer Barrierenschicht (90), die dieselbe Zusammensetzung besitzt wie das Halbleitersubstrat; und
einen Schritt des Ausbildens einer aktiven Schicht (3), die eine kleinere Energielücke besitzt als das Halbleitersubstrat, auf der Barrierenschicht (90).

13. Ein Verfahren zum Herstellen eines Halbleiterlasers, das aufweist:
einen Schritt des Ausbildens einer Beugungsgitterschicht (12) auf einem Halbleitersubstrat (1);
einen Schritt des Ausbildens eines Photolackes auf der Beugungsgitterschicht (12);
einen Schritt des Ausführens eines Elektronenstrahl-Aussetzens des Photolackes mittels allmählichem Ändern einer Dosismenge der Elektronenstrahlen entlang der Resonatorrichtung, um dadurch eine Ätzmaske mit streifenartigen Öffnungen auszubilden, die mit einer vorbestimmten Ganghöhe außerhalb eines im wesentlichen zentralen λ/4-Phasenverschiebungsbereiches (7) der Beugungsgitterschicht (12) und entlang der Resonatorrichtung angeordnet sind, wobei die Breiten der Öffnungen sich entlang der Resonatorrichtung allmählich ändern, um so das Auftreten von Lochbrennen zu unterdrücken;
einen Schritt des Ätzens von in den Öffnungen freiliegenden Bereichen der Beugungsgitterschicht (12);
einen Schritt des Bedeckens der Beugungsgitterschicht mit einer Barrierenschicht (90), die dieselbe Zusammensetzung besitzt wie das Halbleitersubstrat; und
einen Schritt des Ausbildens einer aktiven Schicht (3), die eine kleinere Energielücke besitzt als das Halbleitersubstrat, auf der Barrierenschicht (90).

14. Ein Verfahren zum Herstellen eines Halbleiterlasers gemäß Anspruch 11 oder 12, in dem das Licht-Aussetzen (14, 16) mittels Überlagern eines ersten Licht-Aussetzens (14), das ein Interferenzlicht-Aussetzungsverfahren zum Bestrahlen mit Licht mit einem Lichtintensitätsmuster einer sinusförmigen Welle verwendet, mit einem zweiten Licht-Aussetzen (16) zum Bestrahlen mit Licht mit einem Lichtintensitätsmuster, in dem sich die Lichtintensität entlang der Resonatorrichtung allmählich ändert, ausgeführt wird.

15. Ein Verfahren zum Herstellen eines Halbleiterlasers, das aufweist:
einen Schritt des nacheinander Ausbildens auf einem Halbleitersubstrat (1) einer aktiven Schicht (3), die eine kleinere Energielücke besitzt als das Halbleitersubstrat, einer Barrierenschicht (9), die eine größere Energielücke besitzt als die aktive Schicht, und einer Beugungsgitterschicht (12);
einen Schritt des Ausbildens eines Photolackes auf der Beugungsgitterschicht (12);
einen Schritt des Licht-Aussetzens und Entwickelns des Photolackes, um dadurch eine Ätzmaske (13) mit streifenartigen Öffnungen (18) zu bilden, die mit einer vorbestimmten Ganghöhe außerhalb eines im wesentlichen zentralen λ/4-Phasenverschiebungsbereiches (7) der Beugungsgitterschicht (12) und entlang der Resonatorrichtung angeordnet sind, wobei die Breite der Öffnungen (18) entlang der Resonatorrichtung konstant ist und die Länge der Öffnungen (18) in der Richtung senkrecht zu der Resonatorrichtung sich entlang der Resonatorrichtung allmählich ändert, um so das Auftreten von Lochbrennen zu unterdrücken, und
einen Schritt des Ätzens von in den Öffnungen (18) freiliegenden Bereichen der Beugungsgitterschicht (12).

16. Ein Verfahren zum Herstellen eines Halbleiterlasers, das aufweist:
einen Schritt des Ausbildens einer Beugungsgitterschicht (12) auf einem Halbleitersubstrat (1);
einen Schritt des Ausbildens eines Photolackes auf der Beugungsgitterschicht (12);
einen Schritt des Licht-Aussetzens und Entwickelns des Photolackes, um dadurch eine Ätzmaske (13) mit streifenartigen Öffnungen zu bilden, die mit einer vorbestimmten Ganghöhe außerhalb eines im wesentlichen zentralen λ/4-Phasenverschiebungsbereiches (7) der Beugungsgitterschicht (12) und entlang der Resonatorrichtung angeordnet sind, wobei die Breite der Öffnungen entlang der Resonatorrichtung konstant ist und die Länge der Öffnungen in der Richtung senkrecht zu der Resonatorrichtung sich entlang der Resonatorrichtung allmählich ändert, um so das Auftreten von Lochbrennen zu unterdrücken;
einen Schritt des Ätzens von in den Öffnungen (18) freiliegenden Bereichen der Beugungsgitterschicht (12);
einen Schritt des Abziehens des Photolackes und Bedeckens des verbleibenden Bereiches der Beugungsgitterschicht mit einer Barrierenschicht (90), die dieselbe Zusammensetzung besitzt wie das Halbleitersubstrat; und
einen Schritt des Ausbildens einer aktiven Schicht (3), die eine kleinere Energielücke besitzt als das Halbleitersubstrat, auf der Barrierenschicht (90).

17. Ein Verfahren zum Herstellen eines Halbleiterlasers gemäß Anspruch 15 oder 16, in dem der λ/4-Verschiebungsbereich (17) im wesentlichen im zentralen Bereich der Beugungsgitterschicht (12) mittels Verschieben der Phase des eingebetteten Beugungsgitters (11) um λ/4 (λ: Wellenlänge des Lichts) ausgebildet wird und sich die Breite des eingebetteten Beugungsgitters in der Richtung des λ/4-Verschiebungsbereiches allmählich verringert.

18. Ein Verfahren zum Herstellen eines Halbleiterlasers gemäß Anspruch 15 oder 16, in dem der λ/4-verschiebungsbereich (7) im wesentlichen im zentralen Bereich der Beugungsgitterschicht (12) mittels Verschieben der Phase des eingebetteten Beugungsgitters (11) um λ/4 (λ: Wellenlänge des Lichts) ausgebildet wird und sich die Breite des eingebetteten Beugungsgitters in der Richtung des λ/4-Verschiebungsbereiches allmählich vergrößert.

19. Ein Verfahren zum Herstellen eines Halbleiterlasers, das aufweist:
einen Schritt des nacheinander Ausbildens auf einem Halbleitersubstrat (1) einer aktiven Schicht (3), die eine kleinere Energielücke besitzt als das Halbleitersubstrat (1), und einer Barrierenschicht (9), die eine größere Energielücke besitzt als die aktive Schicht;
einen Schritt des Ausbildens eines wärmebeständigen Filmes (20) auf der Barrierenschicht (9);
einen Schritt des Ausbildens erster Öffnungen (22) in dem wärmebeständigen Film (20), wobei die Längen der Öffnungen (22) in der Richtung senkrecht zu der Resonatorrichtung sich entlang der Resonatorrichtung allmählich ändern, um so das Auftreten von Lochbrennen zu unterdrücken;
einen Schritt des Ausbildens einer Beugungsgitterschicht (21) mittels Kristallwachstum auf der in den ersten Öffnungen (22) freiliegenden Barrierenschicht (9);
einen Schritt des Abziehens des wärmebeständigen Filmes (20) und Ausbildens eines Photolackes (24) auf der Beugungsgitterschicht (21);
einen Schritt des Licht-Aussetzens und Entwickelns des Photolackes (24), um dadurch eine Ätzmaske mit zweiten streifenartigen Öffnungen zu bilden, die mit einer vorbestimmten Ganghöhe außerhalb eines im wesentlichen zentralen λ/4-Phasenverschiebungsbereiches (7) der Beugungsgitterschicht (21) und entlang der Resonatorrichtung angeordnet sind, wobei die Breite entlang der Resonatorrichtung konstant ist; und
einen Schritt des Ätzens der in den zweiten Öffnungen freiliegenden Beugungsgitterschicht (21).

20. Ein Verfahren zum Herstellen eines Halbleiterlasers, das aufweist:
einen Schritt des Ausbildens einer wärmebeständigen Schicht (20) auf einem Halbleitersubstrat (1);
einen Schritt des Ausbildens erster Öffnungen (22) in der wärmebeständigen Schicht (20), wobei die Längen der Öffnungen (22) in der Richtung senkrecht zu der Resonatorrichtung sich entlang der Resonatorrichtung allmählich ändern, um so das Auftreten von Lochbrennen zu unterdrücken;
einen Schritt des Ausbildens einer Beugungsgitterschicht (21) mittels Kristallwachstum auf dem in den ersten Öffnungen (22) freiliegenden Halbleitersubstrat (1);
einen Schritt des Abziehens des wärmebeständigen Filmes (20) und Ausbildens eines Photolackes (24) auf der Beugungsgitterschicht (21);
einen Schritt des Licht-Aussetzens und Entwickelns des Photolackes (24), um dadurch eine Ätzmaske mit streifenartigen Öffnungen zu bilden, die mit einer konstanten Ganghöhe außerhalb eines im wesentlichen zentralen λ/4-Phasenverschiebungsbereiches (7) der Beugungsgitterschicht (21) und entlang der Resonatorrichtung angeordnet sind, wobei die Breiten der Öffnungen entlang der Resonatorrichtung konstant sind;
einen Schritt des Ätzens der in den Öffnungen freiliegenden Beugungsgitterschicht (21);
einen Schritt des Abziehens des Photolackes (24) und Bedeckens des verbleibenden Bereiches der Beugungsgitterschicht (21) mit einer Barrierenschicht (90), die dieselbe Zusammensetzung besitzt wie das Halbleitersubstrat; und
einen Schritt des Ausbildens einer aktiven Schicht (3), die aus einem Material besteht, das eine kleinere Energielücke besitzt als das Halbleitersubstrat, auf der Barrierenschicht.

21. Ein Verfahren zum Herstellen eines Halbleiterlasers gemäß Anspruch 19 oder 20, in dem der λ/4-Verschiebungsöffnungsbereich (7) im wesentlichen im zentralen Bereich der Beugungsgitterschicht (21) mittels Verschieben der Phase der Öffnungen um λ/4 (λ: Wellenlänge des Lichts) ausgebildet wird und sich die Breiten der Öffnungen in der Richtung des λ/4-Verschiebungsöffnungsbereiches allmählich verringern.

22. Ein Verfahren zum Herstellen eines Halbleiterlasers gemäß Anspruch 19 oder 20, in dem der λ/4-Verschiebungsöffnungsbereich (7) im wesentlichen im zentralen Bereich der Beugungsgitterschicht (21) mittels Verschieben der Phase der Öffnungen um λ/4 (λ: Wellenlänge des Lichts) ausgebildet wird und sich die Breiten der Öffnungen in der Richtung des λ/4-Verschiebungsöffnungsbereiches allmählich vergrößern.

23. Ein Verfahren zum Herstellen eines Halbleiterlasers gemäß irgendeinem der Ansprüche 11 bis 22, in dem der Brechungsindex des eingebetteten Beugungsgitters (11; 19) verschieden vom dem der Barrierenschicht (9; 90) ist.

24. Ein Verfahren zum Herstellen eines Halbleiterlasers gemäß irgendeinem der Ansprüche 11 bis 22, in dem die Energielücke des eingebetteten Beugungsgitters (11; 19) größer ist als jene der aktiven Schicht (3) und kleiner als jene der Barrierenschicht (9; 90).

## Revendications

1. Un laser à semi-conducteur qui comprend :
un substrat semi-conducteur (1);
une couche active (3) formée au-dessus du substrat semi-conducteur (1), laquelle présente une bande interdite plus petite que le substrat semi-conducteur ;
une couche de barrière (9) formée sur la couche active, laquelle présente une bande interdite plus grande que la couche active; et
un réseau encastré de diffraction (11) qui comprend une partie (7) à décalage de phase de λ/4 sensiblement dans sa partie centrale et qui est composé de bandes, chacune présentant une largeur le long de la direction résonateur, une longueur dans la direction perpendiculaire à la direction résonateur, et une hauteur, et qui est encastré entre la couche de barrière (9) et une couche de revêtement (4) présentant la même composition que la couche de barrière de manière à s'étendre selon une disposition parallèle à pas constant à l'extérieur de la partie (7) à décalage de phase de λ/4 et le long de la direction résonateur, où la hauteur des bandes est constante et la largeur des bandes à l'extérieur de la partie (7) de décalage de phase de λ/4 est graduellement modifiée le long de la direction résonateur de manière à supprimer l'apparition de brûlage de trous.

2. Un laser à semi-conducteur qui comprend :
un substrat semi-conducteur (1);
un réseau de diffraction encastré (11) qui comprend une partie (7) à décalage de phase de λ/4 sensiblement dans sa partie centrale et qui est composé de bandes, chacune présentant une largeur le long de la direction résonateur, une longueur dans la direction perpendiculaire à la direction résonateur, et une hauteur, et qui est encastré entre le substrat semi-conducteur (1) et une couche de barrière (90) présentant la même composition que le substrat semi-conducteur de manière à s'étendre selon une disposition parallèle à pas constant à l'extérieur de la partie (7) à décalage de phase de λ/4 et le long de la direction résonateur, où la hauteur des bandes est constante et la largeur des bandes à l'extérieur de la partie (7) à décalage de phase de λ/4 est graduellement modifiée le long de la direction résonateur de manière à supprimer l'apparition de brûlage de trous ; et
une couche active (3) qui est formée sur la couche de barrière (90) et qui est composée d'une matière présentant une bande interdite plus petite que le substrat semi-conducteur.

3. Un laser à semi-conducteur selon la revendication 1 ou 2, dans lequel ladite partie (7) à décalage de λ/4 est formée dans sensiblement la partie centrale du réseau encastré de diffraction (11) par décalage de λ/4 de la phase du réseau encastré de diffraction (11) (λ : longueur d'onde de la lumière), et la largeur du réseau encastré de diffraction est graduellement réduite dans la direction de la partie à décalage de λ/4.

4. Un laser à semi-conducteur selon la revendication 1 ou 2, dans lequel ladite partie (7) à décalage de λ/4 est formée dans sensiblement la partie centrale du réseau encastré de diffraction (11) par décalage de λ/4 de la phase du réseau encastré de diffraction (11) (λ : longueur d'onde de la lumière), et la largeur du réseau encastré de diffraction est graduellement augmenté dans la direction de la partie à décalage de λ/4.

5. Un laser à semi-conducteur qui comprend :
un substrat semi-conducteur (1) ;
une couche active (3) formée au-dessus du substrat semi-conducteur, laquelle présente une bande interdite plus petite que le substrat semi-conducteur ;
une couche de barrière (9) formée sur une couche active, laquelle présente une bande interdite plus grande que la couche active ; et
un réseau encastré de diffraction (19) qui comprend une partie (7) à décalage de phase de λ/4 sensiblement dans sa partie centrale et qui est composé de bandes, chacune présentant une largeur le long de la direction résonateur, une longueur dans la direction perpendiculaire à la direction résonateur, et une hauteur, et qui est encastré entre la couche de barrière (9) et une couche de revêtement (4) présentant la même composition que la couche de barrière de manière à s'étendre selon une position parallèle à pas constant à l'extérieur de la partie (7) à décalage de phase de λ/4 et le long de la direction résonateur, où la largeur des bandes est constante et la hauteur des bandes est modifiée le long de la direction résonateur de manière à supprimer l'apparition de brûlage de trous.

6. Un laser à semi-conducteur qui comprend :
un substrat semi-conducteur (1) ;
un réseau encastré de diffraction (19) qui comprend une partie (7) à décalage de phase de λ/4 sensiblement dans sa partie centrale et qui est composé de bandes, chacune présentant une largeur le long de la direction résonateur, une longueur dans la direction perpendiculaire à la direction résonateur, et une hauteur, et qui est encastré entre le substrat semi-conducteur (1) et une couche de barrière (90) présentant la même composition que le substrat semi-conducteur de manière à s'étendre selon une disposition parallèle à pas constant à l'extérieur de la partie (7) à décalage de phase de λ/4 et le long du résonateur, où la largeur des bandes est constante et la hauteur des bandes est modifiée le long de la direction résonateur de manière à supprimer l'apparition de brûlage de trous, et
une couche active (3) qui est formée sur la couche de barrière (90) et qui est composée d'une matière présentant une bande interdite plus petite que le substrat semi-conducteur.

7. Un laser à semi-conducteur selon la revendication 5 ou 6, dans lequel ladite partie (7) à décalage de λ/4 est formée dans sensiblement la partie centrale du réseau encastré de diffraction (19) par décalage de λ/4 de la phase du réseau encastré de diffraction (19) (λ : longueur d'onde de la lumière), et la hauteur du réseau encastré de diffraction est graduellement réduite dans la direction de la partie à décalage de λ/4.

8. Un laser à semi-conducteur selon la revendication 5 ou 6, dans lequel ladite partie (7) à décalage de λ/4 est formée dans sensiblement la partie centrale du réseau encastré de diffraction (19) par décalage de λ/4 de la phase du réseau encastré de diffraction (19) (λ : longueur d'onde de la lumière), et la hauteur du réseau encastré de diffraction est graduellement augmentée dans la direction de la partie à décalage de λ/4.

9. Un laser à semi-conducteur selon une quelconque des revendications 1 à 8, dans lequel l'indice de réfraction du réseau encastré de diffraction (11; 19) est différent de celui de la couche de barrière (9 ; 90).

10. Un laser à semi-conducteur selon une quelconque des revendications 1 à 8, dans lequel la bande interdite du réseau encastré de diffraction (11; 19) est plus grande que celle de la couche active (3) et plus petite que celle de la couche de barrière (9 ; 90).

11. Un procédé de fabrication d'un laser à semi-conducteur qui comprend :
une étape de formation successive, sur un substrat semi-conducteur (1), d'une couche active (3) présentant une bande interdite plus petite que le substrat semi-conducteur, d'une couche de barrière (9) présentant une bande interdite plus grande que la couche active et d'une couche à réseau de diffraction (12);
une étape de formation d'un photorésist sur la couche à réseau de diffraction;
une étape (14 ; 14, 16) d'exposition à la lumière et de développement du photorésist pour ainsi former un masque d'attaque chimique (13) présentant des ouvertures en forme de bande qui sont disposées à un pas prédéterminé à l'extérieur d'une partie (7) à décalage de phase de λ/4 sensiblement centrale de la couche (12) à réseau de diffraction et le long de la direction résonateur, où les largeurs des ouvertures sont graduellement modifiées le long de la direction résonateur de manière à supprimer l'apparition de brûlage de trous, et
une étape d'attaque chimique des parties de la couche (12) à réseau de diffraction exposées dans les ouvertures.

12. Un procédé de fabrication d'un laser à semi-conducteur qui comprend :
une étape de formation d'une couche (12) à réseau de diffraction sur un substrat semi-conducteur (1);
une étape de formation d'un photorésist sur la couche (12) à réseau de diffraction;
une étape (14; 14, 16) d'exposition à la lumière et de développement du photorésist pour ainsi former un masque d'attaque chimique (13) présentant des ouvertures en forme de bande qui sont disposées à un pas prédéterminé à l'extérieur d'une partie (7) à décalage de phase de λ/4 sensiblement centrale de la couche (12) à réseau de diffraction et le long de la direction résonateur, où les largeurs des ouvertures sont graduellement modifiées le long de la direction résonateur de manière à supprimer l'apparition de brûlage de trous ;
une étape d'attaque chimique des parties de la couche (12) à réseau de diffraction exposées dans les ouvertures ;
une étape de recouvrement de la couche à réseau de diffraction à l'aide d'une couche de barrière (90) présentant la même composition que le substrat semi-conducteur, et
une étape de formation, sur la couche de barrière (90), d'une couche active (3) présentant une bande interdite plus petite que le substrat semi-conducteur.

13. Un procédé de fabrication d'un laser à semi-conducteur qui comprend :
une étape de formation d'une couche (12) à réseau de diffraction sur un substrat semi-conducteur (1) ;
une étape de formation d'un photorésist sur la couche (12) à réseau de diffraction ;
une étape consistant à effectuer une exposition de faisceaux d'électrons sur le photorésist en modifiant graduellement une quantité dosée des faisceaux d'électrons le long de la direction résonateur pour ainsi former un masque d'attaque chimique présentant des ouvertures en forme de bande qui sont disposées à un pas prédéterminé à l'extérieur d'une partie (7) à décalage de phase de λ/4 sensiblement centrale de la couche (12) à réseau de diffraction et le long de la direction résonateur, où les largeurs des ouvertures sont graduellement modifiées le long de la direction résonateur de manière à supprimer l'apparition de brûlage de trous ;
une étape d'attaque chimique des parties de la couche (12) à réseau de diffraction exposées dans les ouvertures ;
une étape de recouvrement de la couche à réseau de diffraction à l'aide d'une couche de barrière (90) présentant la même composition que le substrat semi-conducteur ; et
une étape de formation, sur la couche de barrière (90), d'une couche active (3) présentant une bande interdite plus petite que le substrat semi-conducteur.

14. Un procédé de fabrication d'un laser à semi-conducteur selon la revendication 11 ou 12, dans lequel l'exposition à la lumière (14, 16) est effectuée en superposant une première exposition à la lumière (14) utilisant un procédé d'exposition à la lumière d'interférence pour effectuer une irradiation de lumière présentant un motif d'onde sinusoïdal d'intensité lumineuse, sur une seconde exposition de lumière (16) pour effectuer une irradiation de lumière présentant un motif d'intensité lumineuse dans lequel l'intensité lumineuse est graduellement modifiée le long de la direction résonateur.

15. Un procédé de fabrication d'un laser à semi-conducteur qui comprend :
une étape de formation successive, sur un substrat semi-conducteur (1), d'une couche active (3) présentant une bande interdite plus petite que le substrat semi-conducteur, d'une couche de barrière (9) présentant une bande interdite plus grande que la couche active et d'une couche (12) à réseau de diffraction ;
une étape de formation d'un photorésist sur la couche (12) à réseau de diffraction ;
une étape d'exposition à la lumière et de développement du photorésist pour ainsi former un masque d'attaque chimique (13) présentant des ouvertures en forme de bande (18) qui sont disposées à un pas prédéterminé à l'extérieur d'une partie (7) à décalage de phase de λ/4 sensiblement centrale de la couche (12) à réseau de diffraction et le long de la direction résonateur, où la largeur des ouvertures (18) le long de la direction résonateur est constante, et la longueur des ouvertures (18) dans la direction perpendiculaire à la direction résonateur est graduellement modifiée le long de la direction résonateur de manière à supprimer l'apparition de brûlage de tous, et
une étape d'attaque chimique des parties de la couche (12) à réseau de diffraction exposées dans les ouvertures (18).

16. Un procédé de fabrication d'un laser à semi-conducteur qui comprend :
une étape de formation d'une couche (12) à réseau de diffraction sur un substrat semi-conducteur (1) ;
une étape de formation d'un photorésist sur la couche (12) à réseau de diffraction ;
une étape d'exposition à la lumière et de développement du photorésist pour ainsi former un masque d'attaque chimique (13) présentant des ouvertures en forme de bande qui sont disposées à un pas prédéterminé à l'extérieur d'une partie (7) à décalage de phase de λ/4 sensiblement centrale de la couche (12) à réseau de diffraction et le long de la direction résonateur, où la largeur des ouvertures le long de la direction résonateur est constante, et la longueur des ouvertures dans la direction perpendiculaire à la direction résonateur est graduellement modifiée le long de la direction résonateur de manière à supprimer l'apparition de brûlage de trous ;
une étape d'attaque chimique des parties de la couche (12) à réseau de diffraction exposée dans les ouvertures (18) ;
une étape de pelage du photorésist et de recouvrement de la partie restante de la couche à réseau de diffraction à l'aide d'une couche de barrière (90) présentant la même composition que le substrat semi-conducteur, et
une étape de formation, sur la couche de barrière (90), d'une couche active présentant une bande interdite plus petite que le substrat semi-conducteur.

17. Un procédé de fabrication d'un laser à semi-conducteur selon la revendication 15 ou 16, dans lequel ladite partie (7) à décalage de λ/4 est formée dans sensiblement la partie centrale de la couche (12) à réseau de diffraction par décalage de λ/4 de la phase du réseau encastré de diffraction (11) (λ: longueur d'onde de la lumière), et la largeur du réseau encastré de diffraction est graduellement réduite dans la direction de la partie à décalage de λ/4.

18. Un procédé de fabrication d'un laser à semi-conducteur selon la revendication 15 ou 16, dans lequel ladite partie (7) à décalage de λ/4 est formée dans sensiblement la partie centrale de la couche (12) à réseau de diffraction par décalage de λ/4 de la phase du réseau encastré de diffraction (11) (λ : longueur d'onde de la lumière), et la largeur du réseau encastré de diffraction est graduellement augmentée dans la direction de la partie à décalage de λ/4.

19. Un procédé de fabrication d'un laser à semi-conducteur qui comprend :
une étape de formation successive, sur un substrat semi-conducteur (1), d'une couche active (3) présentant une bande interdite plus petite que le substrat semi-conducteur (1) et d'une couche de barrière (9) présentant une bande interdite plus grande que la couche active ;
une étape de formation, sur la couche de barrière (9), d'un film (20) résistant à la chaleur ;
une étape de formation de première ouvertures (22) dans le film (20) résistant à la chaleur, où les longueurs dans la direction perpendiculaire à la direction résonateur des ouvertures (22) sont graduellement modifiées le long de la direction résonateur de manière à supprimer l'apparition de brûlage de trous ;
une étape de formation d'une couche (21) à réseau de diffraction par croissance cristalline sur la couche de barrière (9) exposée dans les premières ouvertures (22) ;
une étape de pelage du film résistant à la chaleur (20) et de formation d'un photorésist (24) sur la couche (21) à réseau de diffraction ;
une étape d'exposition à la lumière et de développement du photorésist (24) pour ainsi former un masque d'attaque chimique présentant de secondes ouvertures en forme de bande qui sont disposées à un pas prédéterminé à l'extérieur d'une partie (7) à décalage de phase de λ/4 sensiblement centrale de la couche (21) à réseau de diffraction et le long de la direction résonateur, où la largeur le long de la direction résonateur est constante ; et
une étape d'attaque chimique de la couche (21) à réseau de diffraction exposée dans les secondes ouvertures.

20. Un procédé de fabrication d'un laser à semi-conducteur qui comprend :
une étape de formation, sur un substrat semi-conducteur (1), d'une couche (20) résistante à la chaleur ;
une étape de formation, dans la couche (20) résistante à la chaleur, de premières ouvertures (22), où les longueurs des ouvertures (22) dans la direction perpendiculaire à la direction résonateur sont graduellement modifiées le long de la direction résonateur de manière à supprimer l'apparition de brûlage de trous ;
une étape de formation d'une couche (21) à réseau de diffraction par croissance cristalline sur le substrat semi-conducteur (1) exposé dans les premières ouvertures (22) ;
une étape de pelage du film (20) résistant à la chaleur et de formation d'un photorésist (24) sur la couche (21) à réseau de diffraction ;
une étape d'exposition à la lumière et de développement du photorésist (24) pour ainsi former un masque d'attaque chimique présentant des ouvertures en forme de bande qui sont disposées à un pas constant à l'extérieur d'une partie (7) à décalage de phase de λ/4 sensiblement constante de la couche (21) à réseau de diffraction et le long de la direction résonateur, où les largeurs des ouvertures le long de la direction résonateur sont constantes ;
une étape d'attaque chimique de la couche (21) à réseau de diffraction exposée dans les ouvertures ;
une étape de pelage du photorésist (24) et de recouvrement de la partie restante de la couche (21) à réseau de diffraction à l'aide d'une couche de barrière (90) présentant la même composition que le substrat semi-conducteur ; et
une étape de formation, sur la couche de barrière, d'une couche active (3) composée d'une matière présentant une bande interdite plus petite que le substrat semi-conducteur.

21. Un procédé de fabrication d'un laser à semi-conducteur selon la revendication 19 ou 20, dans lequel ladite partie (7) des ouvertures à décalage de λ/4 est formée dans sensiblement la partie centrale de la couche (21) à réseau de diffraction par décalage de λ/4 de la phase des ouvertures (λ : longueur d'onde de la lumière), et les largeurs des ouvertures sont graduellement réduites dans la direction de la partie des ouvertures à décalage de λ/4.

22. Un procédé de fabrication d'un laser à semi-conducteur selon la revendication 19 ou 20, dans lequel ladite partie (7) des ouvertures à décalage de λ/4 est formée dans sensiblement la partie centrale de la couche (21) à réseau de diffraction par décalage de λ/4 de la phase des ouvertures (λ : longueur d'onde de la lumière), et les largeurs des ouvertures sont graduellement augmentées dans la direction de la partie des ouvertures à décalage de λ/4.

23. Un procédé de fabrication d'un laser à semi-conducteur selon une quelconque des revendications 11 à 22, dans lequel l'indice de réfraction du réseau encastré de diffraction (11 ; 19) est différent de celui de la couche de barrière (9 ; 90).

24. Un procédé de fabrication d'un laser à semi-conducteur selon une quelconque des revendications 11 à 22, dans lequel la bande interdite du réseau encastré de diffraction (11 ; 19) est plus grande que celle de la couche active (3) et plus petite que celle de la couche de barrière (9 ; 90).
